(19) **Europäisches Patentamt**
**European Patent Office**
**Office européen des brevets**

(11) **EP 3 876 373 B1**

(12) **EUROPÄISCHE PATENTSCHRIFT**

(45) Veröffentlichungstag und Bekanntmachung des Hinweises auf die Patenterteilung:
**05.10.2022 Patentblatt 2022/40**

(51) Internationale Patentklassifikation (IPC):
**H02H 3/34** (2006.01) **H02H 1/00** (2006.01)
**H04J 3/06** (2006.01)

(21) Anmeldenummer: **20160390.9**

(22) Anmeldetag: **02.03.2020**

(52) Gemeinsame Patentklassifikation (CPC):
**H02H 3/34;** H02H 1/0061

(54) **DIFFERENTIALSCHUTZVERFAHREN, DIFFERENTIALSCHUTZEINRICHTUNG UND DIFFERENTIALSCHUTZSYSTEM**

DIFFERENTIAL PROTECTION METHOD, DIFFERENTIAL PROTECTION DEVICE AND DIFFERENTIAL PROTECTION SYSTEM

PROCÉDÉ DE PROTECTION DIFFÉRENTIELLE, DISPOSITIF DE PROTECTION DIFFÉRENTIELLE ET SYSTÈME DE PROTECTION DIFFÉRENTIELLE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**08.09.2021 Patentblatt 2021/36**

(73) Patentinhaber: **Siemens Aktiengesellschaft 80333 München (DE)**

(72) Erfinder:
• **Groß, Matthias**
**13189 Berlin (DE)**
• **Kerger, Torsten**
**14621 Schönwalde-Glien (DE)**
• **Matussek, Robert**
**10365 Berlin (DE)**

(56) Entgegenhaltungen:
**JP-B2- 5 434 309 JP-B2- S6 015 179**
**US-A1- 2012 147 941 US-A1- 2013 181 755**
**US-B2- 8 154 836 US-B2- 10 749 335**

**EP 3 876 373 B1**

**Beschreibung**

Die Erfindung betrifft ein Differentialschutzverfahren zum Überwachen einer Leitung eines elektrischen Energieversorgungsnetzes, bei dem an den Enden der Leitung jeweils mit Messeinrichtungen Stromzeigermesswerte erfasst werden, die Amplitude und Phasenwinkel eines an dem jeweiligen Ende der Leitung fließenden Phasenstroms angeben, wobei die Messeinrichtungen lokale Zeitgeber aufweisen und den Stromzeigermesswerten einen den Zeitpunkt ihrer Erfassung angebenden Zeitstempel zuordnen, wobei zumindest die an einem Ende erfassten Stromzeigermesswerte über eine Kommunikationsverbindung zu einer Auswerteeinrichtung übertragen werden, mittels der Auswerteeinrichtung mit zeitlich einander zugeordneten Stromzeigermesswerten durch vektorielle Addition ein Differenzstromwert gebildet wird, wobei zur zeitlichen Zuordnung der an unterschiedlichen Enden erfassten Stromzeigermesswerte eine den Zeitversatz zwischen den lokalen Zeitgebern der Messeinrichtungen angebende Zeitversatzinformation herangezogen wird, wobei die Zeitversatzinformation mit einem laufzeitbasierten Zeitsynchronisationsverfahren ermittelt wird, und ein einen Fehler hinsichtlich der Leitung angebendes Fehlersignal erzeugt wird, wenn der Differenzstromwert einen vorgegebenen Schwellenwert überschreitet.

Die Erfindung betrifft auch eine entsprechende Differentialschutzeinrichtung zur Durchführung eines solchen Differentialschutzverfahrens sowie ein Differentialschutzsystem mit mindestens zwei solchen Differentialschutzeinrichtungen.

Zur Überwachung von Hoch- und Mittelspannungsleitungen, z.B. Freileitungen oder Kabeln, elektrischer Energieversorgungsnetze wird oft ein Strom-Differentialschutzverfahren (nachfolgend der Einfachheit halber als "Differentialschutzverfahren" bezeichnet) eingesetzt. Dabei wird der an den Enden der überwachten Leitung fließende Strom in Form von Stromzeigermesswerten, die eine Information über Amplitude und Phasenwinkel des Stroms angeben, erfasst und einer Differentialschutzeinrichtung zugeführt. Die Differentialschutzeinrichtung bildet durch vektorielle Addition aus den Stromzeigermesswerten Differenzstromwerte, die zur Beurteilung der Betriebssituation der überwachten Primärkomponente herangezogen werden. Hierzu werden die Differenzstromwerte üblicherweise durch vektorielle Addition und anschließende Betragsbildung aus den Stromzeigermesswerten bestimmt. Im fehlerfreien Fall liegen die Differenzstromwerte nach der Kirchhoff'schen Knotenpunktregel in einem Bereich nahe Null, da hierbei - vereinfacht gesprochen - der in die Komponente hineinfließende Strom vollständig auch wieder aus ihr herausfließt. Dies gilt auch bei durch die überwachte Leitung fließenden Lastströmen oder bei externen Fehlern, also Fehlern, die außerhalb der überwachten Leitung liegen und deren Fehlerströme durch die Leitung hindurchfließen. Ergeben sich hingegen Differenzstromwerte, die einen von Null verschiedenen Schwellenwert überschreiten, so lassen diese auf einen fehlerbehafteten Betriebszustand, z.B. einen internen Kurzschluss, schließen. In diesem Fall muss der vorliegende Fehlerstrom durch Öffnen von die Leitung begrenzenden Schalteinrichtungen, z.B. Leistungsschaltern, unterbrochen werden. Hierfür erzeugt die Differentialschutzeinrichtung ein entsprechendes Fehlersignal, wodurch die Erzeugung eines Schaltsignals für die jeweilige Schalteinrichtung veranlasst werden kann.

Allerdings können bei Differentialschutzsystemen auch im fehlerfreien Betrieb Einflüsse auftreten, die scheinbare Differenzstromwerte ungleich Null zur Folge haben. Dies können beispielsweise Sättigungserscheinungen der Stromwandler, kapazitive Ladeströme oder eine asynchrone Kommunikation über eine Kommunikationsverbindung sein. Aus diesem Grund kann für die Bewertung der Differenzstromwerte kein Ansprechwert von Null angenommen werden.

Bei einer Leitung mit weit auseinander liegenden Enden, beispielsweise einer Leitung von mehreren Kilometern Länge, müssen die Stromzeigermesswerte über eine längere Strecke übertragen werden. In einem solchen Fall ist üblicherweise an jedem der Enden der Leitung eine separate Differentialschutzeinrichtung angeordnet, die den jeweiligen Differenzstromwert aus den eigenen (lokal erfassten) Stromzeigermesswerten und den vom anderen Ende der Leitung empfangenen Stromzeigermesswerten bildet. Bei einer Leitung mit mehreren Enden, z.B. einer verzweigten Leitung, sind zudem Stromzeigermesswerte von jedem der Enden erforderlich, um das Differentialschutzverfahren korrekt durchführen zu können. Dazu müssen die an den jeweiligen Messstellen lokal erfassten Stromzeigermesswerte zwischen den einzelnen Differentialschutzgeräten übertragen werden.

Zur Beurteilung der Betriebssituation der Leitung sind folglich Stromzeigermesswerte von zumindest zwei unterschiedlichen Messstellen an den jeweiligen Enden der überwachten Leitung erforderlich. Bei bestehenden Differentialschutzsystemen werden die Stromzeigermesswerte häufig über eine festverdrahtete Punkt-zu-Punkt-Verbindung (z.B. Kupfer- oder Glasfaserleitungen) übertragen, wodurch eine deterministische Übertragung erreicht wird, d.h., die Übertragungszeit der Messwerte ist hauptsächlich abhängig von der Übertragungsstrecke und der Übertragungsart sowie im Wesentlichen konstant.

Bei jüngeren Differentialschutzsystemen geht man mittlerweile dazu über, die Stromzeigermesswerte anstelle über eine Festverdrahtung über ein Kommunikationsnetzwerk, z.B. ein Telekommunikationsnetzwerk oder ein auf dem IP-Protokoll basierendes Datenkommunikationsnetzwerk, zu übertragen. Dies hat den Vorteil einer kostengünstigeren Kommunikationsinfrastruktur. Außerdem sind Kommunikationsnetzwerke oftmals bereits in der Nähe elektrischer Primärkomponenten, z.B. zwischen sogenannten Unterstationen eines Energieversorgungsnetzes, vorhanden und können ohne zusätzliche Kosten für die Übermittlung der Strommesswerte genutzt werden.

Durch die Nutzung von Kommunikationsnetzwerken zur Übertragung der Strommesswerte verliert man jedoch oftmals den Vorteil der deterministischen Übertragungszeit, so dass ein Problem hinsichtlich der Zuordnung der jeweils zusammengehörenden Stromzeigermesswerte entsteht. Dabei müssen die lokalen und die empfangenen Messwerte nämlich derart zeitlich angeglichen werden, dass bei der Differenzwertbildung jeweils die zu demselben Zeitpunkt erfassten Zeigermesswerte miteinander verglichen werden. Wenn - wie in einem deterministischen Kommunikationssystem möglich - beispielsweise die jeweilige Übertragungszeit der Stromzeigermesswerte bekannt ist, kann der jeweilige Zeitpunkt der Messwerterfassung aus dem Empfangszeitpunkt der Messdaten im lokalen Differentialschutzgerät und der bekannten Übertragungszeit ermittelt werden. Bei Kommunikationssystemen, die hinsichtlich der Übertragungswege und/oder Laufzeiten von Nachrichten nicht deterministisch sind - beispielsweise Telekommunikationsnetzen oder IP- bzw. Ethernet-Netzwerken - ergeben sich hingegen beispielsweise Probleme, weil die Übertragungszeit nicht konstant ist oder Unterschiede der Übertragungszeit in Hin- und Rückrichtung auftreten.

Durch solche Unsicherheiten bei der zeitlichen Angleichung der jeweiligen Stromzeigermesswerte kann eine Überfunktion der Differentialschutzeinrichtung herbeigeführt werden, da bei der vorzeichenrichtigen Addition nicht zusammengehörender Zeigermesswerte ein Differenzstromwert gebildet wird, der einen Fehler hinsichtlich der Primärkomponente vorgibt, der tatsächlich jedoch gar nicht vorhanden ist. Hieraus können Fehlauslösungen resultieren, die den ordnungsgemäßen Betrieb des Energieversorgungsnetzes beeinträchtigen.

Da es für eine zuverlässige Funktionsweise eines Differentialschutzverfahrens wesentlich ist, dass die Stromzeigermesswerte an den Leitungsenden zu jeweils gleichen Zeitpunkten ermittelt werden, besitzen die Messeinrichtungen, mit denen die Stromzeigermesswerte an den Leitungsenden erfasst werden, mittlerweile üblicherweise lokale Zeitgeber bzw. Uhren, die ein Zeitsignal abgeben, das zur Zeitstempelung der erfassten Stromzeigermesswerte verwendet wird. Um beispielsweise die Zeigermesswerte zu jeweils gleichen Zeitpunkten bestimmen zu können, ist es notwendig, diese lokalen Zeitgeber zeitlich miteinander zu synchronisieren, so dass der Zeitversatz zwischen den lokalen Zeitgebern auf null geregelt wird. Dies könnte beispielsweise dadurch erreicht werden, dass die lokalen Zeitgeber über ein externes Zeitgebersystem, z.B. durch das im GPS-Signal enthaltene Zeitsignal, miteinander synchronisiert werden. Hierzu sind jedoch spezielle Empfangssysteme, z.B. GPS-Empfänger, notwendig, die sich erhöhend auf den Gerätepreis auswirken. Die Antennen von GPS-Empfängern benötigen zudem eine freie Sicht zu den Satelliten, so dass entsprechende bauliche Voraussetzungen vorliegen oder geschaffen werden müssen.

Ohne externe Mittel wie GPS-Empfänger, wird eine Synchronisation der lokalen Zeitgeber heutzutage häufig unter Verwendung der Laufzeiten von zwischen den Messeinrichtungen an den Leitungsenden übertragenen Telegrammen durchgeführt (nachfolgend auch als "laufzeitbasierte Zeitsynchronisation" bezeichnet). Ein Beispiel eines laufzeitbasierten Verfahrens wird auch als "Ping-Pong-Verfahren" bezeichnet. Hierbei werden die Sende- und Empfangszeitstempel der übertragenen Telegramme zwischen den jeweiligen Messeinrichtungen ausgetauscht. Als Ergebnis dieses Verfahrens erhält man den Zeitversatz ("Offset") zwischen den lokalen Zeitgebern. Damit ist es entweder möglich, die im Zeitstempel des Telegramms enthaltene Zeitinformation der empfangenen Messwerte der jeweils anderen Messeinrichtung in die eigene Zeit umzurechnen, oder durch Anpassung der Uhrzeit eines der Zeitgeber den Zeitversatz auf null zu regeln. Ein anderes Beispiel ist ein Verfahren, bei dem die an einem zentralen Zeitgeber vorliegende absolute Uhrzeit über Telegramme an die einzelnen Messeinrichtungen verteilt wird. Auch hierbei ist die Laufzeit über die Kommunikationsverbindungen relevant. Beispielsweise kann eine solche Zeitsynchronisation entsprechend dem Standard IEEE1588 erfolgen.

Grundvoraussetzung für dieses Verfahren zur Ermittlung des Zeitversatzes zwischen den Zeitgebern ist allerdings, dass die Laufzeiten der Telegramme bei der Übertragung auf dem Hin- und dem Rückweg gleich sein müssen. In diesem Zusammenhang spricht man von der Gewährleistung von symmetrischen Laufzeiten.

In der Regel gewährleisten Kommunikationsnetzwerke eine hohe Datenqualität, Verfügbarkeit sowie symmetrische Laufzeiten. Trotzdem kann es vorkommen, dass die Voraussetzung von symmetrischen Laufzeiten in einem Kommunikationsnetzwerk nicht komplett sichergestellt werden kann. Beobachtet wurde beispielsweise, dass sich bei einem durch mehrere Kommunikationsnetzwerke oder mehrere Teilnetzwerke eines Kommunikationsnetzwerks verlaufenden Kommunikationspfad der übertragenen Telegramme die Laufzeiten schleichend verändern oder sich plötzlich in großen Sprüngen ändern können. Beobachtet wurde weiterhin, dass sich die Symmetrie der Laufzeiten bei Änderung des Verlaufs des Kommunikationspfades ändert und sich bei Rückkehr auf den ursprünglichen Kommunikationspfad nicht die ursprünglich vorhandenen Laufzeiten einstellen.

Treten unsymmetrische Laufzeiten auf, d.h. die Laufzeiten der Telegramme auf dem Hin- und Rückweg sind nicht gleich, können die empfangenen Stromzeigermesswerte den eigenen Stromzeigermesswerten zeitlich nicht korrekt zugeordnet werden. Es entsteht ein sogenannter "Winkelfehler" $\Delta\Theta$.

In eine asynchrone Kommunikation fließt der Zeitversatz zwischen Hin - und Rücklauf nach Gleichung 1 zur Hälfte ein:

$$\frac{\Delta T}{2} = \frac{t_{S1} - t_{S2}}{2} \tag{1}$$

Der Winkelfehler ΔΘ ergibt sich bei einer Netzfrequenz f zu:

$$\Delta\theta = 2\pi f \cdot \frac{\Delta T}{2} = \pi f \Delta T \tag{2}$$

Ein Laufzeitunterschied von 1ms verursacht damit in einem Netz mit einer Netzfrequenz f=60Hz eine Winkeldrehung von 10,8° (9° bei f=50 Hz). Der daraus resultierende Differentialstrom bestimmt sich nach einfacher geometrischer Gleichung:

$$I_{diff} = 2 \cdot I \cdot sin\left(\frac{\Delta\theta}{2}\right) \tag{3}$$

und beträgt bei f=60Hz rund 19% (16% bei f=50Hz) des durchfließenden Stromes I.

In der Folge würde die jeweilige Differentialschutzeinrichtung einen Differenzstromwert bestimmen, der hinsichtlich der überwachten Leitung in der Realität nicht vorhanden ist. Überschreitet dieser Differenzstromwert einen bestimmten Schwellwert, kommt es zur Fehlabschaltung der überwachten Leitung.

Aus der US 8,154,836 B2 ist ein Differentialschutzverfahren bekannt, bei dem in einem Differentialschutzsystem mit mehr als zwei Enden die lokalen Zeitgeber über ein externes Synchronisationsverfahren, z.B. ein GPS-Signal, oder ein leitungsbasiertes Synchronisationsverfahren synchronisiert werden. Auch ein gemischter Einsatz der verschiedenen Verfahren ist möglich. Bei Ausfall eines externen Zeitsignals kann unter bestimmten Voraussetzungen auf das leitungsbasierte Synchronisationsverfahren umgeschaltet werden, so dass die Zeitgeber weiterhin synchron gehalten werden können.

Aus der EP 3136528 A1 ist außerdem ein Verfahren bekannt, bei dem mit den gemessenen Stromzeigerwerten und einem leitungsspezifischen Parameter, z.B. ein Ladestromwert, ein Dreieck aufgespannt wird und geprüft wird, ob ein sich ergebender Phasenwinkel dem verwendeten Zeitversatz (Offset) entspricht. Man könnte zwar versuchen, eine fehlerhafte Zeitsynchronisierung durch eine unempfindlichere Einstellung des Differentialschutzes zu kompensieren, indem beispielsweise auf einen Stabilisierungswert ein nennstromabhängiger Korrekturwert addiert wird. Da eine solche Stabilisierung allerdings mit skalaren Größen arbeitet, eine Asymmetrie der Datenkommunikation jedoch einen Phasenfehler hervorruft, deckt die Stabilisierung diesen Fehler nur unzureichend ab. Außerdem kann gegen den Fehler nur stabilisiert werden, wenn die Asymmetrie tatsächlich bekannt ist, was in der Regel nicht der Fall ist. Der Differentialschutz wird durch diesen Korrekturwert somit lediglich unempfindlicher.

Weitere Verfahren zur Zeitsynchronisierung der Signale in Differentialschutzvorrichtungen oder zur Kompensation der Asymmetrien sind aus US 2013/181755 und US 2012/147941 bekannt.

Der Erfindung liegt die Aufgabe zugrunde, die Zuverlässigkeit der Zeitsynchronisation der internen Zeitgeber bei einem Differentialschutzsystem weiter zu erhöhen.

Diese Aufgabe wird durch ein Verfahren der eingangs genannten Art gelöst, bei dem ein Quotient der zeitlich einander zugeordneten Stromzeigermesswerte unter Bildung einer Asymmetriegröße gebildet wird, wobei die Asymmetriegröße zur Überprüfung eines Laufzeitunterschieds von über die Kommunikationsverbindung übertragenen Telegrammen verwendet wird, der sich aufgrund richtungsabhängig unterschiedlicher Übertragungszeiten ergibt.

Durch die Quotientenbildung der Stromzeigermessgrößen macht sich bei der Untersuchung insbesondere ein Phasenfehler bemerkbar, der somit vergleichsweise einfach ausgewertet werden kann. Da sich damit die Phasenunterschiede genau bestimmen lassen, kann direkt auf eine fehlerhafte Kommunikation geschlossen werden. Aus der Zeigerdrehung in Grad und der Netzfrequenz lässt sich die Asymmetrie in Millisekunden bestimmen. Damit kann eine unempfindlichere Einstellung des Differentialschutzes entfallen.

Eine vorteilhafte Ausführungsform des erfindungsgemäßen Differentialschutzverfahrens sieht vor, dass zur Quotientenbildung der betragsmäßig kleinere Stromzeigermesswert durch den betragsmäßig größeren Stromzeigermesswert dividiert wird.

Auf diese Weise kann erreicht werden, dass der resultierende Wert der Asymmetriegröße den Wert 1 nicht überschreitet. Dadurch kann die Auswertung der Asymmetriegröße erleichtert werden.

In diesem Zusammenhang kann vorgesehen sein, dass die Asymmetriegröße nur dann gebildet wird, wenn der Quotient der Stromzeigermesswerte einen vorgegebenen minimalen Wert überschreitet.

Auf diese Weise kann eine sichere Unterscheidung zwischen einer durch eine fehlerhafte Laufzeitberechnung erzeugten und einem durch einen tatsächlichen Fehler hervorgerufenen Differenzstromwert erreicht werden. Der vorgegebene minimale Wert kann beispielsweise bei 0,56 liegen.

Außerdem kann gemäß einer weiteren vorteilhaften Ausführungsform des erfindungsgemäßen Differentialschutzverfahrens vorgesehen sein, dass die Lage der Asymmetriegröße in einer komplexen Zahlenebene untersucht wird, und in Abhängigkeit der Lage auf das Vorliegen eines Laufzeitunterschieds geschlossen wird.

In der komplexen Zahlenebene kann hierbei beispielsweise ein Einheitskreis um den Nullpunkt platziert werden. Die Lage der Asymmetriegröße innerhalb des Einheitskreises kann zur Erkennung von Laufzeitunterschieden ausgewertet werden.

Konkret kann in diesem Zusammenhang vorgesehen sein, dass in Abhängigkeit von der Entfernung der Lage der Asymmetriegröße von einem Referenz-Arbeitspunkt eine Fehlermeldung erzeugt wird.

Der Referenz-Arbeitspunkt liegt im idealen fehlerfreien Fall bei -1, also auf dem linken Schnittpunkt des Einheitskreises mit der imaginären Achse der komplexen Zahlenebene. Eine Laufzeitveränderung, die sich wie erläutert durch eine Winkelverschiebung äußert, bewirkt ein Wandern der Asymmetriegröße auf dem Umfang des Einheitskreises. Dabei entfernt sich die Asymmetriegröße vom Referenz-Arbeitspunkt. Die Entfernung kann hierbei beispielsweise in Grad gemessen werden. Je nach Entfernung kann eine Fehlermeldung erzeugt werden. Die Fehlermeldung kann hinsichtlich ihres Inhalts gestuft aufgegeben werden, bei nur geringen Entfernungen vom Referenz-Arbeitspunkt kann ein Hinweis erfolgen, während bei größeren Entfernungen eine Warnung (ggf. unterschiedlicher Intensität) erfolgen kann.

In diesem Zusammenhang kann zudem vorgesehen sein, dass die Erzeugung des einen Fehler hinsichtlich der Leitung angebenden Fehlersignals blockiert wird, wenn die Entfernung der Lage der Asymmetriegröße vom Referenz-Arbeitspunkt eine maximale Entfernung überschreitet.

Damit kann die Differentialschutzfunktion blockiert werden, wenn ein derartig hoher Laufzeitunterschied erkannt worden ist, dass eine zuverlässige Arbeitsweise des Differentialschutzes nicht mehr gewährleistet ist.

Eine weitere vorteilhafte Ausführungsform des erfindungsgemäßen Differentialschutzverfahrens sieht zudem vor, dass die Lage des Referenz-Arbeitspunktes in Abhängigkeit eines kapazitiven Ladestroms der Leitung bestimmt wird.

Ein signifikanter Ladestrom kann nämlich Auswirkungen auf die Lage des Referenz-Arbeitspunktes im fehlerfreien Fall haben. Daher ist der kapazitive Ladestrom vorteilhafterweise bei der Bestimmung des Referenz-Arbeitspunktes zu berücksichtigen, damit die korrekte Funktionsweise der Erkennung von Laufzeitunterschieden gewährleistet ist.

Außerdem kann vorgesehen sein, dass die Asymmetriegröße nur dann gebildet wird, wenn der Betrag zumindest eines der Stromzeigermesswerte den kapazitiven Ladestrom der Leitung um einen vorgegebenen Faktor übersteigt.

Ein signifikanter kapazitiver Ladestrom kann nämlich im Extremfall den Referenz-Arbeitspunkt sogar in Richtung des Ursprungs oder der rechten Seite des Einheitskreises verschieben. Damit wäre keine zuverlässige Unterscheidung zwischen einem Laufzeitunterschied und einem tatsächlichen Fehler mehr möglich. Also sollte das Verhältnis des durch die Stromzeigermesswerte angegebenen Laststroms und des kapazitiven Ladestroms zur Beurteilung eines erlaubten Arbeitsbereiches der Laufzeitunterschiedserkennung herangezogen werden. Der Faktor kann beispielsweise bei 2,3 liegen.

Außerdem ist gemäß einer weiteren vorteilhaften Ausführungsform des erfindungsgemäßen Differentialschutzverfahrens vorgesehen, dass die Asymmetriegröße nur gebildet wird, wenn die Beträge der Stromzeigermesswerte unterhalb einer vom Nennstrom des Energieversorgungsnetzes abhängigen Schwelle liegen.

Bei einem sehr hohen Laststrom ist die Bestimmung eines kapazitiven Ladestroms nicht mehr möglich, so dass die korrekte Arbeitsweise der Laufzeitunterschiedserkennung nicht mehr gewährleistet wird. Daher wird der Arbeitsbereich abhängig vom Laststrom begrenzt. Beispielsweise kann die zu verwendende Schwelle bei 1,5 $I_n$ liegen.

Schließlich kann gemäß einer weiteren vorteilhaften ausführungsform des erfindungsgemäßen Differentialschutzverfahrens vorgesehen sein, dass in der komplexen Zahlenebene ein Bereich festgelegt wird, innerhalb dessen die Lage der Symmetriegröße erlaubt ist, und die Überprüfung des Laufzeitunterschieds ausgesetzt wird, wenn die Asymmetriegröße außerhalb des festgelegten Bereichs liegt.

Auf diese Weise kann quasi ein Arbeitsbereich der Laufzeitunterschiedserkennung festgelegt werden, so dass bei Abweichungen davon die Funktion blockiert wird.

Die oben genannte Aufgabe wird auch durch eine Differentialschutzeinrichtung zum Überwachen einer Leitung eines elektrischen Energieversorgungsnetzes gelöst, mit einer einen lokalen Zeitgeber aufweisenden Messeinrichtung, die dazu eingerichtet ist, an einem Ende der Leitung Stromzeigermesswerte zu erfassen, die Amplitude und Phasenwinkel eines an dem Ende der Leitung fließenden Phasenstroms angeben, und den Stromzeigermesswerten einen den Zeitpunkt ihrer Erfassung angebenden Zeitstempel zuzuordnen, mit einer Kommunikationseinrichtung, die dazu eingerichtet ist, Stromzeigermesswerte über eine Kommunikationsverbindung mit einer anderen Differentialschutzeinrichtung auszutauschen, und mit einer Auswerteeinrichtung, die dazu eingerichtet ist, mit zeitlich einander zugeordneten eigenen Stromzeigermesswerten einerseits und von der anderen Differentialschutzeinrichtung empfangenen Stromzeigermesswerten andererseits durch vektorielle Addition einen Differenzstromwert zu bilden, wobei zur zeitlichen Zuordnung der an unterschiedlichen Enden erfassten Stromzeigermesswerte eine den Zeitversatz zwischen den lokalen Zeitgebern der Messeinrichtungen der Differentialschutzeinrichtungen angebende Zeitversatzinformation herangezogen wird, wobei

die Zeitversatzinformation mit einem laufzeitbasierten Zeitsynchronisationsverfahren ermittelt wird, und ein einen Fehler hinsichtlich der Leitung angebendes Fehlersignal zu erzeugen, wenn der Differenzstromwert einen vorgegebenen Schwellenwert überschreitet.

Erfindungsgemäß ist vorgesehen, dass die Differentialschutzeinrichtung dazu eingerichtet ist, einen Quotienten der zeitlich einander zugeordneten Stromzeigermesswerte unter Bildung einer Asymmetriegröße zu bilden, wobei die Asymmetriegröße zur Überprüfung eines Laufzeitunterschieds von über die Kommunikationsverbindung übertragenen Telegrammen verwendet wird, der sich aufgrund richtungsabhängig unterschiedlicher Übertragungszeiten ergibt.

Die Aufgabe wird schließlich auch durch ein Differentialschutzsystem zum Überwachen einer Leitung eines elektrischen Energieversorgungsnetzes gelöst, mit zumindest zwei Differentialschutzeinrichtungen, wobei an jedem Ende der Leitung eine Differentialschutzeinrichtung vorgesehen ist, und mit einer Kommunikationsverbindung, mit der die einzelnen Differentialschutzeinrichtungen zur Übertragung von Stromzeigermesswerten in Verbindung stehen, wobei jede der Differentialschutzeinrichtungen eine einen lokalen Zeitgeber aufweisende Messeinrichtung umfasst, die dazu eingerichtet ist, an einem jeweiligen Ende der Leitung Stromzeigermesswerte zu erfassen, die Amplitude und Phasenwinkel eines an dem Ende der Leitung fließenden Phasenstroms angeben, und den Strommesswerten einen den Zeitpunkt ihrer Erfassung angebenden Zeitstempel zuzuordnen, wobei jede der Differentialschutzeinrichtungen eine Kommunikationseinrichtung umfasst, die dazu eingerichtet ist, Stromzeigermesswerte über die Kommunikationsverbindung mit der jeweils anderen Differentialschutzeinrichtung auszutauschen, und wobei zumindest eine der Differentialschutzeinrichtungen eine Auswerteeinrichtung umfasst, die dazu eingerichtet ist, mit zeitlich einander zugeordneten eigenen Stromzeigermesswerten einerseits und von der anderen Differentialschutzeinrichtung empfangenen Stromzeigermesswerten andererseits durch vorzeichenrichtige Addition einen Differenzstromwert zu bilden, wobei zur zeitlichen Zuordnung der an unterschiedlichen Enden erfassten Stromzeigermesswerte eine den Zeitversatz zwischen den lokalen Zeitgebern der Messeinrichtungen der Differentialschutzeinrichtungen angebende Zeitversatzinformation herangezogen wird, wobei die Zeitversatzinformation mit einem laufzeitbasierten Zeitsynchronisationsverfahren ermittelt wird, und ein einen Fehler hinsichtlich der Leitung angebendes Fehlersignal zu erzeugen, wenn der Differenzstromwert einen vorgegebenen Schwellenwert überschreitet.

Erfindungsgemäß ist diesbezüglich vorgesehen, dass die zumindest eine der Differentialschutzeinrichtungen dazu eingerichtet ist, einen Quotienten der zeitlich einander zugeordneten Stromzeigermesswerte unter Bildung einer Asymmetriegröße zu bilden, wobei die Asymmetriegröße zur Überprüfung eines Laufzeitunterschieds von über die Kommunikationsverbindung übertragenen Telegrammen verwendet wird, der sich aufgrund richtungsabhängig unterschiedlicher Übertragungszeiten ergibt. Hinsichtlich der erfindungsgemäßen Differentialschutzeinrichtung bzw. des erfindungsgemäßen Differentialschutzsystems gelten alle zu dem erfindungsgemäßen Differentialschutzverfahren voranstehend und nachfolgend gemachten Ausführungen und umgekehrt in entsprechender Weise, insbesondere sind die erfindungsgemäße Differentialschutzeinrichtung und das erfindungsgemäße Differentialschutzsystem zur Durchführung des erfindungsgemäßen Differentialschutzverfahrens in jeder beliebigen Ausführungsform oder einer Kombination beliebiger Ausführungsformen eingerichtet. Auch hinsichtlich der Vorteile der erfindungsgemäßen Differentialschutzeinrichtung bzw. des erfindungsgemäßen Differentialschutzsystems wird auf die zu dem erfindungsgemäßen Differentialschutzverfahren beschriebenen Vorteile verwiesen.

Die Erfindung wird durch die angehängten Patentansprüche definiert und nachfolgend anhand eines Ausführungsbeispiels näher erläutert. Die spezifische Ausgestaltung des Ausführungsbeispiels ist für die allgemeine Ausgestaltung des erfindungsgemäßen Verfahrens und der erfindungsgemäßen Einrichtung in keiner Weise einschränkend zu verstehen; vielmehr können einzelne Ausgestaltungsmerkmale des Ausführungsbeispiels in beliebiger Weise frei untereinander und mit den voranstehend beschriebenen Merkmalen kombiniert werden.

Hierzu zeigen:

Figur 1 — eine schematische Ansicht eines Differentialschutzsystems zur Überwachung einer Leitung eines elektrischen Energieversorgungsnetzes;

Figuren 2 und 3 — eine schematische Ansicht eines Differentialschutzsystems bei einem äußeren Fehler und bei einem inneren Fehler;

Figur 4 — eine schematische Ansicht eines Differentialschutzsystems zur Erläuterung der Übertragung von Stromzeigermesswerten;

Figur 5 — ein Diagramm zur Erläuterung der Entstehung eines Winkelfehlers durch einen Laufzeitunterschied bei der Übertragung der Stromzeigermesswerte;

Figur 6 — ein Diagramm in der komplexen Zahlenebene zur Erläuterung der Lage von fehlerhaften und fehlerfreien Betriebszuständen;

| Figur 7 | ein erstes Diagramm zur Erläuterung der Auswertung eines Asymmetriegröße; |
|---|---|

Figuren 8 und 9 Schaltbilder und Diagramme zur Erläuterung des Einflusses eines kapazitiven Ladestroms auf die Asymmetriegröße;

Figur 10 ein zweites Diagramm zur Erläuterung der Auswertung der Asymmetriegröße unter Berücksichtigung eines kapazitiven Ladestroms; und

Figur 11 ein drittes Diagramm mit unterschiedlichen Bereichen zur Erläuterung der Auswertung der Asymmetriegröße.

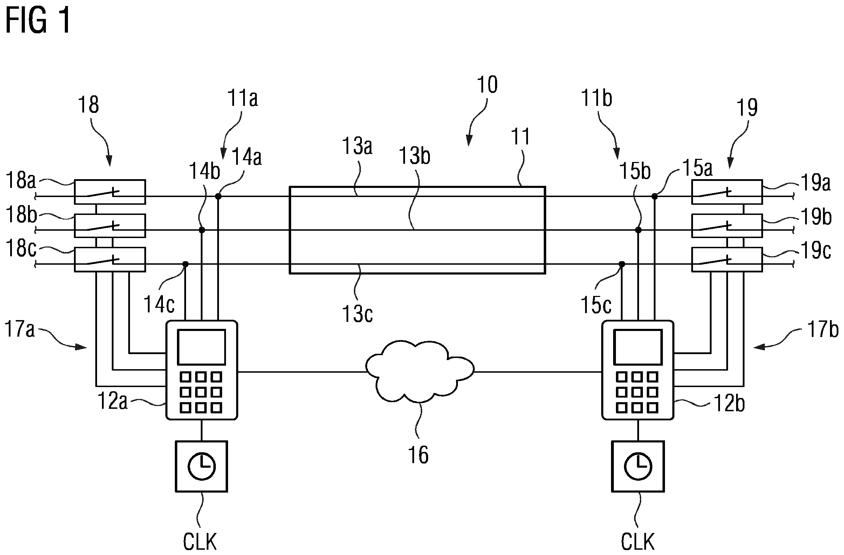

Figur 1 zeigt einen Teil 10 eines im Weiteren nicht näher dargestellten elektrischen Energieversorgungsnetzes. Der Teil 10 umfasst eine dreiphasige Leitung 11, die beispielsweise als Freileitung oder als Kabel ausgebildet sein kann. Die Leitung 11 wird an ihrem ersten Ende 11a mittels einer ersten Differentialschutzeinrichtung 12a und an ihrem zweiten Ende 11b mittels einer zweiten Differentialschutzeinrichtung 12b hinsichtlich auf der Leitung auftretender Fehler, z.B. Kurzschlüsse, überwacht. Hierfür werden für jede Phase 13a, 13b, 13c der Leitung 11 mit ersten Stromwandlern 14a-c an einer ersten Messstelle an dem ersten Ende 11a der Leitung 11 und zweiten Stromwandlern 15a-c an einer zweiten Messstelle an dem zweiten Ende 11b der Primärkomponente 11 Stromsignale erfasst und einer jeweiligen Messeinrichtung der Differentialschutzeinrichtungen 12a, 12b zugeführt. Aus den analogen Stromsignalen werden Stromzeigermesswerte erzeugt, die eine Angabe von Amplitude und Phasenwinkel des Stromsignals zum Erfassungszeitpunkt angeben. Die Erzeugung der Stromzeigermesswerte inklusive einer A/D-Wandlung kann in der Messeinrichtung der jeweiligen Differentialschutzeinrichtung 12a, 12b, in den Stromwandlern selbst oder in einem geeigneten zwischen geschalteten Messgerät (in Figur 1 nicht dargestellt), z.B. einer Phasor Measurement Unit (PMU), einer Remote Terminal Unit (RTU) oder einer Merging Unit erfolgen. Letztlich werden die erzeugten Stromzeigermesswerte einer Auswerteeinrichtung, z.B. einer CPU oder einem Signalprozessor, der jeweiligen Differentialschutzeinrichtung 12a, 12b zugeführt.
Die Differentialschutzeinrichtungen 12a bzw. 12b sind durch eine in Figur 1 nur schematisch angedeutete Kommunikationsverbindung 16 miteinander verbunden, bei der es sich z.B. um ein IP-basiertes Kommunikationsnetz oder ein Telekommunikationsnetz handeln kann. Allerdings kann auch jede weitere Kommunikationsverbindung beliebiger Art zur Verbindung der Differentialschutzeinrichtungen 12a und 12b eingesetzt werden. Über diese Kommunikationsverbindung 16 können der jeweiligen Differentialschutzeinrichtung 12a bzw. 12b die Stromzeigermesswerte vom jeweils anderen Ende 11a, 11b der Leitung 11 zur Verfügung gestellt werden, das heißt, es können in jeder Differentialschutzeinrichtung 12a bzw. 12b für jede Phase 13a, 13b, 13c der Leitung 11 jeweils Paare aus an beiden Enden 11a und 11b aufgenommenen Stromzeigermesswerten gebildet werden.
Anhand der in beiden Differentialschutzeinrichtungen 12a und 12b verfügbaren Strommesswerte von beiden Enden 11a und 11b der Primärkomponente 11 kann in einer oder beiden Differentialschutzeinrichtungen 12a bzw. 12b mittels der Auswerteeinrichtung durch vektorielle Addition der Stromzeigermesswerte und anschließende Betragsbildung pro Phase ein Differenzstromwert gebildet und mit einem Schwellenwert verglichen werden.
Bei fehlerfreier Leitung 11 ist der pro Phase in die Leitung 11 eintretende Strom (nahezu) gleich dem aus der Leitung 11 austretenden Strom, so dass sich bei vektorieller Addition der Stromzeigermesswerte ein Zeiger mit dem Betrag von etwa Null ergeben müsste. In der Realität wird der Differenzstromwert jedoch immer einen Wert ungleich Null annehmen, er wird aber unterhalb eines vorgegebenen Schwellenwertes liegen. Dies ist beispielsweise auf einen kapazitiven Ladestrom auf der überwachten Leitung zurückzuführen, der bewirkt, dass der Differenzstromwert auch im fehlerfreien Falle quasi nie dauerhaft exakt den Wert Null annimmt. Daneben können auch beispielsweise Wandlerungenauigkeiten und Messfehler zu diesem Effekt beitragen. Der vorgegebene Schwellenwert kann entweder statisch oder dynamisch, beispielsweise an die Höhe der jeweiligen Phasenströme angepasst, festgelegt werden.
Der Schwellenwert kann als separater Parameter festgelegt sein. Es kann jedoch auch vorgesehen sein, eine Schwellenwertüberschreitung durch Auswertung der Lage eines Messwertpaares aus dem Differenzstromwert und einem zugehörigen Stabilisierungswert in einem Auslösediagramm zu prüfen. Hierzu werden aus zusammengehörenden, d.h. gleichzeitig erfassten, Stromzeigermesswerten Differenzstromwerte und zugehörige Stabilisierungswerte gebildet und die Lage des aus einem Differenzstromwert und einem Stabilisierungswert bestehenden Messwertpaares in dem Auslösediagramm geprüft. Liegt das Messwertpaar innerhalb eines Auslösebereichs, wird auf einen Fehler hinschlicht der überwachten Leitung geschlossen und das Fehlersignal erzeugt.
Überschreitet für eine bestimmte Phase der Differenzstromwert den vorgegebenen Schwellenwert, so weist dies auf einen Fehler hinsichtlich der betreffenden Phase der Leitung 11 hin, bei dem es sich beispielsweise um einen Kurzschluss mit Erdbeteiligung oder einen zwei- oder mehrpoligen Kurzschluss, d.h. einen Kurzschluss zwischen zwei oder mehr Phasen der Primärkomponente, handeln kann. Für diejenige Phase, bei der der Fehler erkannt worden ist, erzeugen die Differentialschutzeinrichtungen 12a und 12b ein Fehlersignal, wodurch die Abgabe eines Auslösesignals über Steuerleitungen 17a, 17b an phasenselektiv schaltbare Leistungsschalter 18 bzw. 19 bewirkt wird. Das Auslösesignal veranlasst den entsprechenden phasenbezogenen Leistungsschalter 18a, 18b, 18c bzw. 19a, 19b, 19c zum Öffnen seiner Schaltkontakte, so dass die von dem Fehler betroffene Phase 13a, 13b, 13c vom restlichen Energieversorgungsnetz abgetrennt wird.

Liegt beispielsweise auf der Phase 13b ein Kurzschluss mit Erdbeteiligung vor, so erkennen die Differentialschutzeinrichtungen 12a bzw. 12b dies anhand eines den jeweiligen Schwellenwert übersteigenden Differenzstromwertes und geben Auslösesignale an die phasenbezogenen Leistungsschalter 18b bzw. 19b ab, um die Phase 13b der Leitung 11 von dem Energieversorgungsnetz abzutrennen.

Obwohl gemäß Figur 1 eine dreiphasige Leitung 11 mit lediglich zwei Enden 11a bzw. 11b gezeigt ist, kann das erfindungsgemäße Verfahren auch bei beliebigen ein- oder mehrphasigen Leitungen mit zwei oder mehr Enden, beispielsweise elektrischen Sammelschienen mit mehreren Abzweigen, eingesetzt werden.

Außerdem kann in Abweichung zur Darstellung gemäß Figur 1 auch vorgesehen sein, dass die Stromzeigermesswerte zu einer einzigen Differentialschutzeinrichtung übertragen und dort ausgewertet werden. In diesem Fall reicht es aus, an den Enden 11a, 11b der Leitung 11 Messeinrichtungen zu platzieren, die die Stromzeigermesswerte erfassen und an die Differentialschutzeinrichtung übermitteln. Diese Differentialschutzeinrichtung könnte an einem der Leitungsenden, aber auch an beliebiger anderer Stelle, beispielsweise als zentrale Differentialschutzeinrichtung in einer Schaltanlagenstation oder einer Leitstelle oder auch in einer Datenverarbeitungscloud, angeordnet sein.

Um den Differenzstromwert korrekt ermitteln zu können, ist es notwendig, dass die zu seiner Bildung verwendeten Stromzeigermesswerte tatsächlich gleichzeitig an den Enden 11a, 11b der Leitung 11 erfasst worden sind. Üblicherweise stellt sich jedoch, insbesondere bei der Übertragung der Stromzeigermesswerte über eine vergleichsweise lange Kommunikationsstrecke, eine zeitliche Verzögerung ein, so dass der lokal erfasste Stromzeigermesswert nicht ohne weiteres einem an einem entfernten Ende erfassten und übertragenen Stromzeigermesswert verknüpft werden kann. Bei Verwendung nicht gleichzeitig erfasster Stromzeigermesswerte können sich auch bei eigentlich fehlerfreier Leitung Differenzstromwerte ergeben, die den Schwellenwert überschreiten und damit zur Abgabe eines Fehlersignals führen würden.

Zur zeitlichen Zuordnung der Stromzeigermesswerte werden diese daher üblicherweise mit einer Markierung in Form eines Zeitstempels versehen, der den Zeitpunkt ihrer Erfassung angibt. Durch Auswahl derjenigen Stromzeigermesswerte von unterschiedlichen Enden der Leitung, die einen zueinander passenden Zeitstempel aufweisen, kann sichergestellt werden, dass der Differenzstromwert korrekt berechnet wird. Diese Vorgehensweise setzt jedoch voraus, dass die zur Erfassung der Stromzeigermesswerte verwendeten Messeinrichtungen jeweils lokale Uhren bzw. Zeitgeber (CLK) aufweisen, die miteinander synchronisiert sind oder zumindest einen bekannten Zeitversatz aufweisen. Um dies zu erreichen, findet eine kontinuierliche Ermittlung eines etwaigen Zeitversatzes zwischen den Zeitgebern (CLK) der jeweiligen Messeinrichtungen statt, der entweder zur Nachjustierung eines Zeitgebers (CLK) oder von der Auswerteeinrichtung der Differentialschutzeinrichtung zur zeitlichen Zuordnung der Stromzeigermesswerte verwendet wird. Im letztgenannten Fall muss zur zeitlichen Zuordnung der Stromzeigermesswerte der ermittelte Zeitversatz von dem Zeitstempel des Stromzeigermesswertes derjenigen Messeinrichtung abgezogen werden, die den Zeitgeber mit der im Vergleich zum anderen Zeitgeber (CLK) vorgehenden Uhrzeit aufweist.

Um den Zeitversatz zwischen den Zeitgebern (CLK) der Messeinrichtungen zu ermitteln, kann ein laufzeitbasiertes Synchronisationsverfahren, z.B. das sogenannte "Ping-Pong-Verfahren" eingesetzt werden. Dabei wird diejenige Zeitdauer gemessen, die benötigt wird, um über die Übertragungsstrecke zwischen den beiden Messeinrichtungen ein erstes Telegramm in die eine Richtung und anschließend ein zweites Telegramm in die andere Richtung zu übertragen. Die übertragenen Telegramme weisen jeweils einen Zeitstempel auf, der den Zeitpunkt ihres Versendens angibt. Außerdem halten die Messeinrichtungen den Empfangszeitpunkt des jeweiligen Telegramms fest. Anhand der Zeitstempel kann die Zeitdauer für die reine Übertragung der Telegramme (ohne etwaige Zeitverzögerungen zwischen dem Empfang des ersten Telegramms und dem Versenden des zweiten Telegramms) ermittelt werden. Die ermittelte Zeitdauer wird halbiert und ergibt die Laufzeit auf der Kommunikationsstrecke für ein in eine Übertragungsrichtung übertragenes Telegramm. Anhand der mit den Telegrammen übertragenen Zeitstempel sowie den Empfangszeitpunkten und der nunmehr bekannten Laufzeit können die Messeinrichtungen den Zeitversatz zwischen den Zeitgebern (CLK) der Messeinrichtungen bestimmen. Weitere Details zum Ping-Pong-Verfahren finden sich in der eingangs genannten US 8,154,836 B2.

Die Ermittlung des Zeitversatzes mit einem laufzeitbasierten Verfahren kann jedoch nur dann zuverlässige Ergebnisse liefern, wenn die Kommunikationsstrecke zwischen den Messeinrichtungen symmetrisch ist, d.h., wenn die Laufzeiten der Telegramme für den Hinweg und den Rückweg über die Kommunikationsstrecke gleich sind. Bei einer unsymmetrischen Kommunikationsstrecke, d.h. ungleichen Laufzeiten für den Hin- und Rückweg, liefert das Verfahren eine nicht korrekte Laufzeit, so dass der unter Verwendung der Laufzeit ermittelte Zeitversatz auch fehlerhaft ist. In diesem Fall werden für die Berechnung des Differenzstromzeigerwertes fälschlicherweise nicht gleichzeitig erfasste Stromzeigermesswerte verwendet. Dies kann im ungünstigsten Fall in der Ermittlung eines Differenzstromzeigerwertes resultieren, der - trotz eigentlich fehlerfreier Leitung - den Schwellenwert übersteigt.

Es ist daher sicherzustellen, dass eine umgehende Erkennung erfolgt, wenn eine Kommunikationsstrecke von Anfang an unsymmetrisch ist oder sich von einer symmetrischen Kommunikationsstrecke - schleichend oder sprunghaft - zu einer unsymmetrischen Kommunikationsstrecke wandelt. Beispielsweise kann eine zuvor symmetrische Kommunikationsstrecke durch Schaltvorgänge von Switches oder Routern, die den Kommunikationspfad eines Telegramms verändern, ein unsymmetrisches Verhalten annehmen. Auch können sich Alterungseffekte oder Topologieänderungen auf das Verhalten einer Kommunikationsstrecke auswirken.

Gemäß dem nachfolgend vorgeschlagenen Verfahren kann das Vorliegen eines unsymmetrischen Verhaltens einer Kommunikationsstrecke bzw. anderer die Laufzeitmessung verfälschender Umstände vergleichsweise einfach erkannt werden. Hierzu werden lediglich die ohnehin vorhandenen Stromzeigermesswerte benötigt.

Wie bereits beschrieben, werden beim Leitungsdifferentialschutz phasenselektiv die Stromzeigermesswerte auf Freileitungen und Kabeln mit zwei oder mehr Enden gemessen und anschließend die vektorielle Summe der Stromzeigermesswerte über alle Messstationen gebildet. Nach der Kirchhoff'schen Knotenpunktregel muss diese Summe zu jedem Zeitpunkt Null sein. Dies gilt für den fehlerfreien Zustand der Leitung und im Fall eines äußeren Fehlers gleichermaßen. Tritt ein Fehler im Schutzbereich (innerer Fehler), also auf der Leitung selbst, auf, entstehen Differenzströme die ungleich Null sind. Anhand dieses Kriteriums stellt der Leitungsdifferentialschutz einen Fehler fest und setzt ein Auslösesignal an einen Leistungsschalter ab, der den Fehler abschaltet.

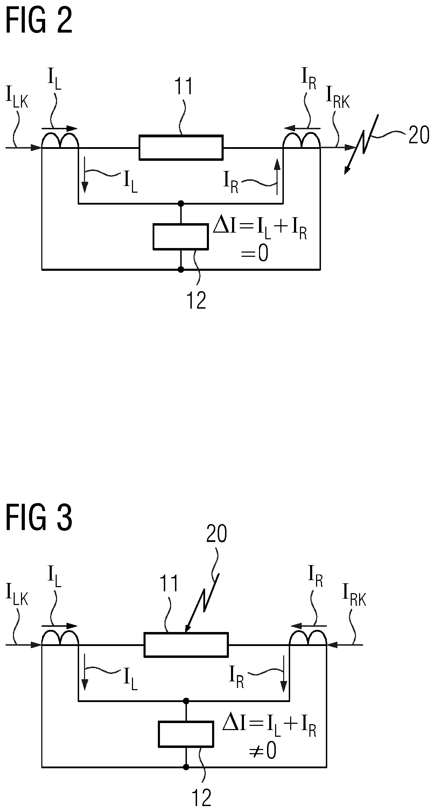

Figur 2 zeigt in diesem Zusammenhang das vereinfachte einphasige Grundschaltbild des Differentialschutzes für zwei Enden einer Leitung 11 für den Fall eines äußeren Fehlers, während Figur 3 ein entsprechendes Grundschaltbild für den Fall eines inneren Fehlers zeigt. Der Fehler ist jeweils durch ein Blitzsymbol 20 angedeutet. Vereinfacht ist in Figuren 2 und 3 lediglich eine Differentialschutzeinrichtung 12 dargestellt.

Die Indizes L und R kennzeichnen die Bezugsposition. $I_L$ entspricht dem Stromzeigermesswert an dem lokalen ("local") und $I_R$ dem Stromzeigermesswert am entfernten ("remote") Ende der Leitung. Zu beachten ist, dass Ströme, die in den Schutzbereich hineinfließen positiv und abfließende Ströme negativ gezählt werden. Die Kurzschlussströme der Leitung sind mit dem Index K versehen.

Allerdings treten auch im fehlerfreien Betrieb Einflüsse auf, die einen von Null verschiedenen Differenzstromwert zur Folge haben. Dies können beispielsweise Sättigungserscheinungen der Stromwandler, kapazitive Ladeströme oder eine asynchrone Kommunikation der Leitung sein. Aus diesem Grund kann kein Ansprechwert von Null angenommen werden.

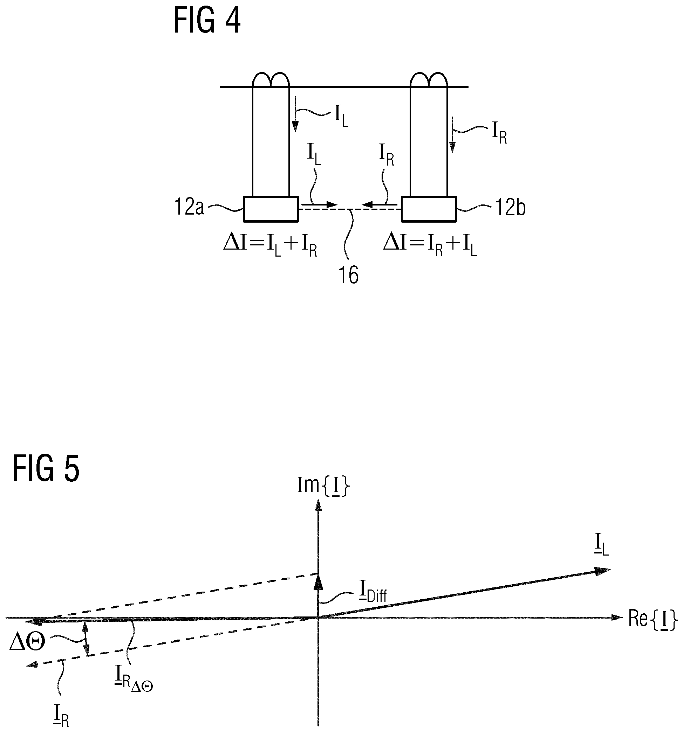

Für lange Leitungen müssen die Stromzeigermesswerte mittels serieller Kommunikation, z.B. durch Lichtwellenleiter übertragen werden. Dies ist schematisch in Figur 4 angedeutet, in der die Differentialschutzeinrichtungen 12a und 12b ihre Stromzeigermesswerte $I_L$ und $I_R$ über die Kommunikationsverbindung 16 an die jeweils andere Differentialschutzeinrichtung 12a, 12b übertragen. Alternativ kann die Übertragung auch zu nur einer der Differentialschutzeinrichtungen 12a,b oder zu einer zentralen Einrichtung stattfinden.

Zur Synchronisierung der Zeigerwerte wird beispielsweise das sogenannte "Ping-Pong"-Verfahren angewandt, dieses setzt allerdings gleiche Übertragungszeiten $t_{S1}$ für den Hinweg und $t_{S2}$ für den Rückweg voraus ($t_{S1} = t_{S2}$). Treten Unterschiede (Asymmetrien) in den Laufzeiten auf, entstehen ungewollte Differenzströme. Die Stromzeigermesswerte $I_L$ und $I_R$ werden um einen Fehlwinkel $\Delta\Theta$ gedreht, wie es in Figur 5 zu sehen ist (als gedrehter Stromzeiger ist $I_{R\Delta\Theta}$ eingetragen), so dass auch im fehlerfreien Fall ein scheinbarer Differenzstrom $I_{Diff}$ ungleich Null entsteht. Der entstehende Fehlwinkel $\Delta\Theta$ und sich daraus ergebende fehlerhafte Ströme sind oben im Zusammenhang mit den Gleichungen (1) bis (3) beschrieben.

Ziel ist es daher, diesen Störeinfluss zu erkennen und dadurch die Arbeitsweise des Differentialschutzes zu überwachen. Dazu werden die komplexen Stromzeigermessgrößen der Leitungsenden in einem Verhältnis zueinander dargestellt, um eine Asymmetriegröße AS zu bilden. Bevorzugt wird hierbei, dass der betragsmäßig kleinere Stromzeigermesswert durch den betragsmäßig größeren Stromzeigermesswert dividiert wird. Im Fall einer Leitung mit zwei Leitungsenden würde ein solcher Quotient damit wie folgt gebildet werden:

$$AS = \frac{I_L}{I_R}, \quad \text{für} \quad \left|I_R\right| > \left|I_L\right| \quad \text{bzw.} \quad AS = \frac{I_R}{I_L}, \quad \text{für} \quad \left|I_L\right| > \left|I_R\right|$$

Idealerweise, d.h. ohne innere Fehler sowie Störeinflüsse entspricht der Stromzeigermesswert an dem einen Ende dem negativen Stromzeigermesswert an dem anderen Ende. Somit läge die Asymmetriegröße in der komplexen Schreibweise damit bei:

$$AS = \frac{I_R}{I_L} = \frac{I_R}{-I_R} = -1 + 0j$$

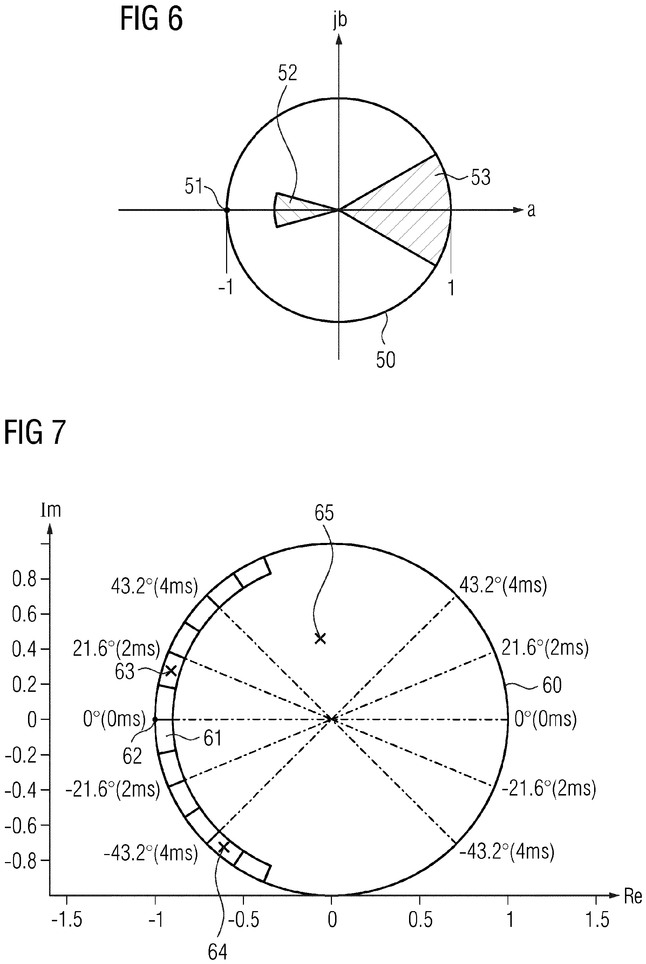

Das Ergebnis kann in der komplexen Zahlenebene in einem Einheitskreis 50 dargestellt werden, wie er in Figur 6 angedeutet ist. Da stets der betragsmäßig kleinere Stromzeigermesswert durch den betragsmäßig größeren dividiert wird, kann die hierbei entstehende Asymmetriegröße den Einheitskreis 50 nicht verlassen. Die ideale Lage der Asymmetriegröße im fehlerfreien Fall (nur elektrische Last) oder im Fall externer Fehler ist durch Punkt 51 angegeben. Diese ideale Lage wird im Fall zu vernachlässigender kapazitiver Ladeströme auch als Referenz-Arbeitspunkt bezeichnet. Hier gilt: $I_R = -I_L$. Die Bereiche innerer Fehler mit einseitiger Einspeisung (Bereich 52) sowie bei beidseitiger Einspeisung (Bereich 53) sind im Einheitskreis gesondert markiert.

Treten Asymmetrien der Laufzeiten von Telegrammen in unterschiedlichen Übertragungsrichtungen von 2 bzw. 4ms in einem 60 Hz Netz auf, ergeben sich ausgehend vom Referenz-Arbeitspunkt Winkelabweichungen von 21,6° bzw. 43,2°. Die Beträge der Stromzeigermesswerte ändern sich nicht. Zur Sicherstellung symmetrischer Laufzeiten wird daher eine Überwachungsfunktion vorgeschlagen, die die Winkelabweichungen bzw. Phasendrehungen bei gleichbleibenden Beträgen der Stromzeigermesswerte auf der linken Seite des Einheitskreises überwacht. Beispielsweise kann die Überwachungsfunktion Abweichungen bis zu 6ms erkennen und entsprechend melden. Zur Gewährleistung einer Toleranz gegen betragsmäßige Abweichungen der Stromzeigermesswerte kann zudem ein Bereich von z.B. 0,9 <|AS|< 1 abgedeckt werden. Ein entsprechend bemessener Überwachungsbereich 61 ist in Figur 7 in einem Einheitskreis 60 eingetragen. Der Referenz-Arbeitspunkt der Asymmetriegröße ist mit 62 gekennzeichnet. Die Überwachung der Laufzeiten ist nur innerhalb des Überwachungsbereichs 61 aktiv (z.B. bei Punkten 63 und 64), außerhalb davon (z.B. bei Punkt 65) kann nicht mehr sicher zwischen einem tatsächlichen Fehler und einem übermäßigen Laufzeitunterschied unterschieden werden. Je nach Entfernung (in Grad) der Lage der Asymmetriegröße vom Referenz-Arbeitspunkt können verschiedene Stufen der Dringlichkeit einer Fehlermeldung erzeugt werden.

In der Realität, insbesondere bei langen Leitungen, führen kapazitive Ladeströme ebenfalls zu Winkelfehlern. Außerdem bewirken sie Fehler in den Strombeträgen. Hierdurch kann die Arbeitsweise der Überwachungsfunktion eingeschränkt werden. Kapazitive Ladeströme $I_C$ auf Freileitungen oder Kabeln lassen sich wie folgt bestimmen:

$$\underline{I_C} = \frac{U_{LL}}{\sqrt{3}} \cdot 2\pi \cdot f_n \cdot C_b{}' \cdot l \qquad (4)$$

mit

$I_C$: zu ermittelnder Ladestromwert;
$U_{LL}$: Leiter-Leiterspannung des Energieversorgungsnetzes;
$f_N$: Nennfrequenz des Energieversorgungsnetzes;
$C_b{}'$: kapazitiver Belag der Leitung;
l: Länge der Leitung.

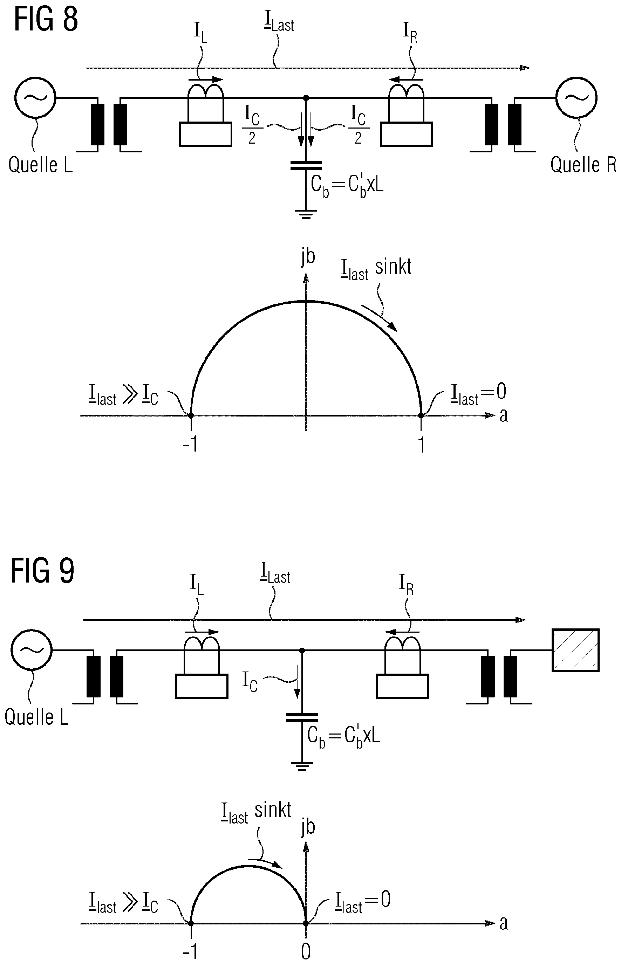

Ist der Laststrom im Vergleich zum kapazitiven Ladestrom gering, können in Abhängigkeit der Einspeisung (einseitig, beidseitig) Drehungen bzgl. des Referenz-Arbeitspunktes auftreten, wie sie beispielhaft in Figuren 8 (beidseitige Einspeisung) und 9 (einseitige Einspeisung) angedeutet sind. Dabei zeigen die Figuren 8 und 9 jeweils ein Prinzipschaltbild eines Differentialschutzsystems und daneben die Auswirkungen einer Verschiebung des Referenz-Arbeitspunktes durch den kapazitiven Ladestrom im Einheitskreis in der komplexen Zahlenebene.

Konkret ergibt sich die in Figur 8 angedeutete Drehung bei beidseitiger Einspeisung aus dem in Gleichung (5) dargestellten Zusammenhang:

$$AS = \frac{\underline{I_R}}{\underline{I_L}} = a + bj = \frac{-I_{Last} + \frac{\underline{I_C}}{2}}{I_{Last} + \frac{\underline{I_C}}{2}} \qquad (5)$$

Bei im Vergleich zum Laststrom $I_{Last}$ großen Werten des kapazitiven Ladestroms $I_C$ strebt der Wert der Gleichung (5) gegen den Wert 1 und damit auf die rechte Seite des Einheitskreises. Wie in Figur 6 gezeigt, liegt der Wert der Asymmetriegröße dort jedoch auch im Falle eines tatsächlichen Fehlers, so dass keine eindeutige Aussage getroffen werden kann.

Außerdem ergibt sich die in Figur 9 angedeutete Drehung bei einseitiger Einspeisung aus dem in Gleichung (6) dargestellten Zusammenhang:

$$AS = \frac{\underline{I_R}}{\underline{I_L}} = a + bj = \frac{-I_{Last}}{I_{Last} + \underline{I_C}} \qquad (6)$$

Bei im Vergleich zum Laststrom $I_{Last}$ großen Werten des kapazitiven Ladestroms $\underline{I}_C$ strebt der Wert der Gleichung (6) gegen den Wert 0 und damit in den Mittelpunkt des Einheitskreises. Wie in Figur 6 gezeigt, ist auch für diesen Bereich des Einheitskreises keine eindeutige Aussage möglich.

Als Ergebnis der Betrachtung kann damit festgehalten werden, dass der Einfluss des kapazitiven Ladestromes mit sinkendem Laststrom steigt und Potential aufweist, die Referenz-Arbeitspunkte je nach Einspeisung in den Koordinatenursprung bzw. in die rechte Halbebene zu verschieben. Da aus der vorherigen Betrachtung der Fehlerzustände im Zusammenhang mit Figur 6 entnommen werden konnte, dass lediglich im Bereich der linken Halbebene des Einheitskreises eine Überwachung der Laufzeiten von Telegrammen ohne einen Einfluss auf die Funktion des Differentialschutzes möglich ist, kann festgestellt werden, dass die Überwachung der Laufzeiten nur innerhalb bestimmter Bereiche des kapazitiven Ladestroms möglich ist.

So ist beispielsweise eine Mindeststromschwelle des Ladestromes im Verhältnis zum fließenden Laststrom einzuhalten. Befindet sich der Betrag mindestens eines der Stromzeigermesswerte (entweder der lokale oder der entfernte Stromzeiger) über einem Schwellenwert $I_S$, der sich aus dem kapazitiven Ladestrom multipliziert mit einem Faktor x ergibt, ist die Laufzeit-Überwachung freigegeben:

$$Max\left(\left|\underline{I}_L\right|, \left|\underline{I}_R\right|\right) > I_S, \ \texttt{mit} \ I_S = x \cdot \left|\underline{I}_C\right|$$

Ein geeigneter Wert für x kann beispielsweise bei x=2,3 liegen. Damit ist sichergestellt, dass der Einfluss des Ladestromes gering genug ist, sodass der sich ergebende Referenz-Arbeitspunkt der Asymmetriegröße im fehlerfreien Fall weiterhin in der linken Halbebene des Einheitskreises auftritt.

Erfüllen also die Stromzeigermesswerte die oben angegebene Bedingung, befindet sich somit mindestens einer der Beträge der Stromzeiger über dem 2,3-fachen des Betrages des Ladestromes, ist die Überwachungsfunktion freigegeben.

Die maximal mögliche lastabhängige (ohmsch, induktiv oder kapazitiv) Winkelabweichung läge bei diesem Wert bei rund 25,4° ausgehend vom Referenz-Arbeitspunkt ohne kapazitiven Ladestrom (Figur 7). Auf diese Weise ist sichergestellt, dass sich die Lage der Asymmetriegröße unabhängig von der angeschlossenen Last in der linken Halbebene befindet.

Um das Verfahren noch zuverlässiger auszugestalten, sollte das Verhältnis der Beträge der Stromzeigermesswerte im fehlerfreien Fall oder bei äußeren Fehlern zudem nicht unter einem vorgegebenen minimalen Wert, z.B. den Wert 0,56 liegen. Diese Grenze ist in Figur 6 beispielhaft als linker Rand des Fehlerbereichs 52 illustriert und bildet den Grenzwert der Empfindlichkeit des Differentialschutzes bei inneren einpoligen Fehlern mit hohem Fehlerübergangswiderstand.

Bei äußeren Fehlern, die einen hohen Stromfluss zur Folge haben, sinkt hingegen der Einfluss des kapazitiven Ladestromes. Die genaue Bestimmung des Ladestromes schlägt fehl. Auch in diesen Fällen ist die Überwachungsfunktion zu deaktivieren. Sinnvoll erscheint es, den Arbeitsbereich der Überwachungsfunktion auf einen oberen Wert, z.B. das 1,5-fache des Nennstromes, zu begrenzen:

$$\left|\underline{I}_L\right| \leq 1,5 \cdot I_N \ \texttt{bzw.} \ \left|\underline{I}_R\right| \leq 1,5 \cdot I_N$$

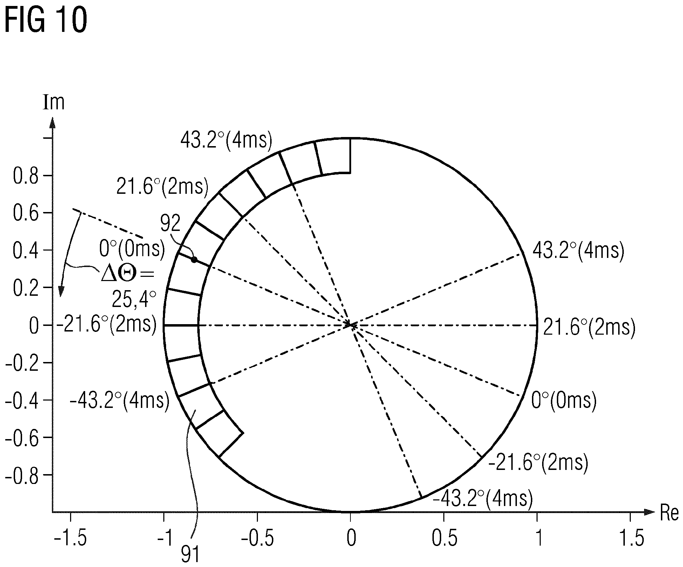

Sind Last- sowie Leitungsdaten bekannt, lässt sich aus dem nach Gleichung (4) berechneten ermittelten kapazitiven Ladestrom die Höhe der eingangs- und ausgangsseitigen Ströme aus einem passenden Netzmodel berechnen. Aus diesen lässt sich dann der entsprechende Referenz-Arbeitspunkt unter Einfluss des kapazitiven Ladestromes bestimmen. Die Überwachung der Laufzeiten berücksichtigt den neuen Referenz-Arbeitspunkt und passt den Überwachungsbereich entsprechend an. Hierzu zeigt Figur 10 ein der Darstellung in Figur 7 entsprechendes Diagramm mit einem Überwachungsbereich 91, der unter Berücksichtigung des kapazitiven Ladestroms ermittelt worden ist. Der Referenz-Arbeitspunkt 92 wurde durch den Ladestrom sowohl hinsichtlich der Winkeldrehung als auch hinsichtlich seines Betrages im Vergleich zu dem Referenz-Arbeitspunkt 62 der Figur 7 verschoben. Die Winkeldrehung des Referenz-Arbeitspunktes durch kapazitive Ladeströme kann im in der Figur 10 dargestellten Beispiel bei maximal 25,4° liegen. Außerdem wird die Toleranz der Betragsunterschiede für die Asymmetriegröße auf 0,8 <|AS|< 1 erweitert. Somit bleibt weiterhin eine Toleranz von 10 % in beide Richtungen gewahrt.

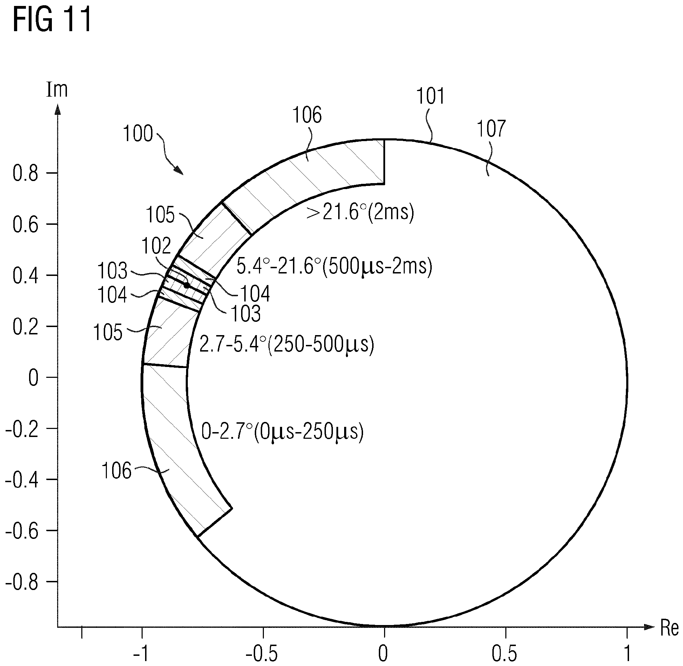

Insgesamt wird hierbei eine Funktionalität zur Überwachung der Laufzeiten von zur Zeitsynchronisation genutzten Telegrammen über die Kommunikationsverbindung parallel zur Funktion des Differentialschutzes implementiert. Durch die Überwachung der Lage der Asymmetriegröße (Winkelabweichung in Grad) bezogen auf einen Referenz-Arbeitspunkt kann direkt auf eine unsymmetrische Kommunikation geschlossen werden (aus der Zeigerdrehung in Grad lässt sich die Asymmetrie in ms bestimmen). Das Anzeichen für eine auftretende Asymmetrie ist, dass sich die Lage der Asymmetriegröße um einen bestimmten Winkel vom bekannten Referenz-Arbeitspunkt für den fehlerfreien Fall fortbewegt, sich aber weiterhin in dem gezeichneten Überwachungsbereich befindet. Das bedeutet, dass sich die Beträge der Stromzeigermesswerte zueinander nicht verändert haben. Es kann eine Unterteilung des Überwachungsbereiches vorgenommen werden, um für bestimmte Abstände der Asymmetriegröße vom Referenz-Arbeitspunkt unterschiedlich zu reagieren. Dies ist in Figur 11 angedeutet. In Figur 11 ist der bekannte Einheitskreis 101 gezeigt. Der Referenz-Arbeitspunkt 102 ist für den Fall eines bestehenden kapazitive Ladestroms berechnet worden. Ein Überwachungsbereich 100 definiert den erlaubten Arbeitsbereich der Laufzeit-Überwachung. Außerhalb des Überwachungsbereichs 100, im Bereich 107, wird die ÜberwachungsFunktion blockiert, um keine Überschneidungen mit tatsächlichen Fehlerfällen zu erlauben. Symmetrisch um den Referenz-Arbeitspunkt 102 sind Bereiche unterschiedlicher Reaktion auf eine Abweichung eingetragen.

Ein Normalbereich 103 gibt erlaubte Abweichungen an, die zu keiner Reaktion führen müssen. In Bereichen 104 geringer Kommunikationsasymmetrien (z.B. bei 250µs - 500µs) kann eine Meldung abgesetzt werden, die einen Hinweis auf die bestehende leichte Asymmetrie enthält. Bei stärkeren Asymmetrien (Bereich 105, bei 0,5ms - 2ms) kann eine Fehlermeldung erfolgen, die eine Warnung umfasst und bei zu hoher Asymmetrie bspw. bei Asymmetrien von über 2ms (Bereich 106) kann der Differentialschutz komplett blockiert werden.

Wird der Überwachungsbereich 100 verlassen, liegt ein anderer Fehler vor. Entweder liegt tatsächlich ein innerer Fehler vor, auf den der Differentialschutz ansprechen muss, oder es liegt ein Messfehler, wie z.B. bei Stromwandlersättigung vor. In diesen Fällen ist die Überwachungsfunktion deaktiviert.

Der Differentialschutz kann durch die zusätzliche Überwachung der Laufzeiten empfindlicher eingestellt werden, da Laufzeitunterschiede, die sich auf die Zeitsynchronisation auswirken können, nun direkt und bezüglich ihrer Höhe erkannt werden können. Laufzeitänderungen können unabhängig davon, ob sie sprunghaft oder schleichend sind, erkannt werden. Dadurch dass die Stromzeigermesswerte direkt in der komplexen Ebene im Verhältnis zueinander dargestellt werden, können Betrags- und Winkelfehler voneinander getrennt betrachtet werden. Im Fall eines inneren Fehlers wird die Überwachungsfunktionalität deaktiviert, da sich die Lage der Asymmetriegröße aus dem Überwachungsbereich entfernt.

Obwohl die Erfindung vorstehend im Detail durch bevorzugte Ausführungsbeispiele näher illustriert und beschrieben worden ist, ist die Erfindung nicht durch die offenbarten Beispiele eingeschränkt und andere Variationen können vom Fachmann hieraus abgeleitet werden, ohne den Schutzumfang der nachfolgenden Patentansprüche zu verlassen.

**Patentansprüche**

1. Differentialschutzverfahren zum Überwachen einer Leitung (11) eines elektrischen Energieversorgungsnetzes, bei dem

   - an den Enden (11a, 11b) der Leitung (11) jeweils mit Messeinrichtungen Stromzeigermesswerte erfasst werden, die Amplitude und Phasenwinkel eines an dem jeweiligen Ende (11a, 11b) der Leitung (11) fließenden Phasenstroms angeben, wobei die Messeinrichtungen lokale Zeitgeber (CLK) aufweisen und den Stromzeigermesswerten einen den Zeitpunkt ihrer Erfassung angebenden Zeitstempel zuordnen;
   - zumindest die an einem Ende erfassten Stromzeigermesswerte über eine Kommunikationsverbindung (16) zu einer Auswerteeinrichtung übertragen werden;
   - mittels der Auswerteeinrichtung mit zeitlich einander zugeordneten Stromzeigermesswerten durch vektorielle Addition ein Differenzstromwert gebildet wird, wobei zur zeitlichen Zuordnung der an unterschiedlichen Enden (11a, 11b) erfassten Stromzeigermesswerte eine den Zeitversatz zwischen den lokalen Zeitgebern (CLK) der Messeinrichtungen angebende Zeitversatzinformation herangezogen wird, wobei
   - die Zeitversatzinformation mit einem laufzeitbasierten Zeitsynchronisationsverfahren ermittelt wird; und
   - ein einen Fehler hinsichtlich der Leitung (11) angebendes Fehlersignal erzeugt wird, wenn der Differenzstromwert einen vorgegebenen Schwellenwert überschreitet;

  **dadurch gekennzeichnet, dass**

   - ein Quotient der zeitlich einander zugeordneten Stromzeigermesswerte unter Bildung einer Asymmetriegröße gebildet wird, wobei die Asymmetriegröße zur Überprüfung eines Laufzeitunterschieds von über die Kommunikationsverbindung (16) übertragenen Telegrammen verwendet wird, der sich aufgrund richtungsabhängig unterschiedlicher Übertragungszeiten ergibt.

2. Differentialschutzverfahren nach Anspruch 1,
  **dadurch gekennzeichnet, dass**

- zur Quotientenbildung der betragsmäßig kleinere Stromzeigermesswert durch den betragsmäßig größeren Stromzeigermesswert dividiert wird.

3. Differentialschutzverfahren nach Anspruch 2,
   **dadurch gekennzeichnet, dass**

   - die Asymmetriegröße nur dann gebildet wird, wenn der Quotient der Stromzeigermesswerte einen vorgegebenen minimalen Wert überschreitet.

4. Differentialschutzverfahren nach Anspruch 2 oder 3,
   **dadurch gekennzeichnet, dass**

   - die Lage der Asymmetriegröße in einer komplexen Zahlenebene untersucht wird; und
   - in Abhängigkeit der Lage auf das Vorliegen eines Laufzeitunterschieds geschlossen wird.

5. Differentialschutzverfahren nach Anspruch 4,
   **dadurch gekennzeichnet, dass**

   - in Abhängigkeit von der Entfernung der Lage der Asymmetriegröße von einem Referenz-Arbeitspunkt eine Fehlermeldung erzeugt wird.

6. Differentialschutzverfahren nach Anspruch 5,
   **dadurch gekennzeichnet, dass**

   - die Erzeugung des einen Fehler hinsichtlich der Leitung angebenden Fehlersignals blockiert wird, wenn die Entfernung der Lage der Asymmetriegröße vom Referenz-Arbeitspunkt eine maximale Entfernung überschreitet.

7. Differentialschutzverfahren nach Anspruch 5 oder 6,
   **dadurch gekennzeichnet, dass**

   - die Lage des Referenz-Arbeitspunktes in Abhängigkeit eines kapazitiven Ladestroms der Leitung bestimmt wird.

8. Differentialschutzverfahren nach einem der vorigen Ansprüche,
   **dadurch gekennzeichnet, dass**

   - die Asymmetriegröße nur dann gebildet wird, wenn der Betrag zumindest eines der Stromzeigermesswerte einen kapazitiven Ladestrom der Leitung um einen vorgegebenen Faktor übersteigt.

9. Differentialschutzverfahren nach einem der vorigen Ansprüche,
   **dadurch gekennzeichnet, dass**

   - die Asymmetriegröße nur gebildet wird, wenn die Beträge der Stromzeigermesswerte unterhalb einer vom Nennstrom des Energieversorgungsnetzes abhängigen Schwelle liegen.

10. Differentialschutzverfahren nach einem der Ansprüche 4 bis 9,
    **dadurch gekennzeichnet, dass**

    - in der komplexen Zahlenebene ein Bereich festgelegt wird, innerhalb dessen die Lage der Symmetriegröße erlaubt ist;

    und

    - die Überprüfung des Laufzeitunterschieds ausgesetzt wird, wenn die Asymmetriegröße außerhalb des festgelegten Bereichs liegt.

11. Differentialschutzeinrichtung (12a, 12b) zum Überwachen einer Leitung (11) eines elektrischen Energieversorgungsnetzes, mit

- einer einen lokalen Zeitgeber (CLK) aufweisenden Messeinrichtung, die dazu eingerichtet ist, an einem Ende (11a, 11b) der Leitung (11) Stromzeigermesswerte zu erfassen, die Amplitude und Phasenwinkel eines an dem Ende (11a, 11b) der Leitung (11) fließenden Phasenstroms angeben, und den Stromzeigermesswerten einen den Zeitpunkt ihrer Erfassung angebenden Zeitstempel zuzuordnen;
- einer Kommunikationseinrichtung, die dazu eingerichtet ist, Stromzeigermesswerte über eine Kommunikationsverbindung (16) mit einer anderen Differentialschutzeinrichtung (12a, 12b) auszutauschen; und
- einer Auswerteeinrichtung, die dazu eingerichtet ist, mit zeitlich einander zugeordneten eigenen Stromzeigermesswerten einerseits und von der anderen Differentialschutzeinrichtung (12a, 12b) empfangenen Stromzeigermesswerten andererseits durch vektorielle Addition einen Differenzstromwert zu bilden, wobei zur zeitlichen Zuordnung der an unterschiedlichen Enden (11a, 11b) erfassten Stromzeigermesswerte eine den Zeitversatz zwischen den lokalen Zeitgebern (CLK) der Messeinrichtungen der Differentialschutzeinrichtungen (12a, 12b) angebende Zeitversatzinformation herangezogen wird, wobei die Zeitversatzinformation mit einem laufzeitbasierten Zeitsynchronisationsverfahren ermittelt wird, und ein einen Fehler hinsichtlich der Leitung (11) angebendes Fehlersignal zu erzeugen, wenn der Differenzstromwert einen vorgegebenen Schwellenwert überschreitet;

**dadurch gekennzeichnet, dass**

- die Differentialschutzeinrichtung (12a, 12b) dazu eingerichtet ist, einen Quotienten der zeitlich einander zugeordneten Stromzeigermesswerte unter Bildung einer Asymmetriegröße zu bilden, wobei die Asymmetriegröße zur Überprüfung eines Laufzeitunterschieds von über die Kommunikationsverbindung (16) übertragenen Telegrammen verwendet wird, der sich aufgrund richtungsabhängig unterschiedlicher Übertragungszeiten ergibt.

12. Differentialschutzsystem zum Überwachen einer Leitung (11) eines elektrischen Energieversorgungsnetzes, mit zumindest zwei Differentialschutzeinrichtungen (12a, 12b), wobei an jedem Ende (11a, 11b) der Leitung (11) eine Differentialschutzeinrichtung (12a, 12b) vorgesehen ist, und mit einer Kommunikationsverbindung (16), mit der die einzelnen Differentialschutzeinrichtungen (12a, 12b) zur Übertragung von Stromzeigermesswerten in Verbindung stehen;

- wobei jede der Differentialschutzeinrichtungen (12a, 12b)

- eine einen lokalen Zeitgeber (CLK) aufweisenden Messeinrichtung umfasst, die dazu eingerichtet ist, an einem jeweiligen Ende (11a, 11b) der Leitung (11) Stromzeigermesswerte zu erfassen, die Amplitude und Phasenwinkel eines an dem Ende (11a, 11b) der Leitung (11) fließenden Phasenstroms angeben, und den Strommesswerten einen den Zeitpunkt ihrer Erfassung angebenden Zeitstempel zuzuordnen;
- eine Kommunikationseinrichtung umfasst, die dazu eingerichtet ist, Stromzeigermesswerte über die Kommunikationsverbindung (16) mit der jeweils anderen Differentialschutzeinrichtung (12a, 12b) auszutauschen;

- und wobei zumindest eine der Differentialschutzeinrichtungen (12a, 12b)

- eine Auswerteeinrichtung umfasst, die dazu eingerichtet ist, mit zeitlich einander zugeordneten eigenen Stromzeigermesswerten einerseits und von der anderen Differentialschutzeinrichtung (12a, 12b) empfangenen Stromzeigermesswerten andererseits durch vektorielle Addition einen Differenzstromwert zu bilden, wobei zur zeitlichen Zuordnung der an unterschiedlichen Enden erfassten Stromzeigermesswerte eine den Zeitversatz zwischen den lokalen Zeitgebern der Messeinrichtungen der Differentialschutzeinrichtungen (12a, 12b) angebende Zeitversatzinformation herangezogen wird, wobei die Zeitversatzinformation mit einem laufzeitbasierten Zeitsynchronisationsverfahren ermittelt wird, und ein einen Fehler hinsichtlich der Leitung (11) angebendes Fehlersignal zu erzeugen, wenn der Differenzstromwert einen vorgegebenen Schwellenwert überschreitet;

**dadurch gekennzeichnet, dass**

- die zumindest eine der Differentialschutzeinrichtungen (12a, 12b) dazu eingerichtet ist, einen Quotienten der zeitlich einander zugeordneten Stromzeigermesswerte unter Bildung einer Asymmetriegröße zu bilden, wobei die Asymmetriegröße zur Überprüfung eines Laufzeitunterschieds von über die Kommunikationsverbindung (16) übertragenen Telegrammen verwendet wird, der sich aufgrund richtungsabhängig unterschiedlicher Übertragungszeiten ergibt.

**Claims**

1. Differential protection method for monitoring a line (11) of a power grid, in which

   - current phasor measured values are captured in each case with measuring devices at the ends (11a, 11b) of the line (11), said values indicating the amplitude and phase angle of a phase current flowing at the respective end (11a, 11b) of the line (11), wherein the measuring devices have local timers (CLK) and allocate a timestamp to the current phasor measured values indicating the time of their capture;
   - at least the current phasor measured values captured at one end are transmitted via a communication connection (16) to an evaluation device;
   - a differential current value is formed through vectorial addition by means of the evaluation device with current phasor measured values temporally allocated to one another, wherein time delay information indicating the time delay between the local timers (CLK) of the measuring devices is used for the temporal allocation of the current phasor measured values captured at different ends (11a, 11b), wherein
   - the time delay information is determined using a transit-time-based time synchronization method; and
   - a fault signal indicating a fault affecting the line (11) is generated if the differential current value exceeds a predefined threshold value;

   **characterized in that**

   - a quotient of the current phasor measured values temporally allocated to one another is formed with the formation of an asymmetry variable, wherein the asymmetry variable is used to check a transit time difference of messages transmitted via the communication connection (16), which transit time difference arises on account of transmission times which are different depending on the direction.

2. Differential protection method according to Claim 1, **characterized in that**

   - the current phasor measured value with the smaller absolute value is divided by the current phasor measured value with the larger absolute value in order to form the quotient.

3. Differential protection method according to Claim 2, **characterized in that**

   - the asymmetry variable is formed only when the quotient of the current phasor measured values exceeds a predefined minimum value.

4. Differential protection method according to Claim 2 or 3, **characterized in that**

   - the position of the asymmetry variable in a complex number plane is analyzed; and
   - the presence of a transit time difference is inferred on the basis of the position.

5. Differential protection method according to Claim 4, **characterized in that**

   - a fault message is generated on the basis of the distance between the position of the asymmetry variable and a reference operating point.

6. Differential protection method according to Claim 5, **characterized in that**

   - the generation of the fault signal indicating a fault affecting the line is blocked if the distance between the position of the asymmetry variable and the reference operating point exceeds a maximum distance.

7. Differential protection method according to Claim 5 or 6, **characterized in that**

   - the position of the reference operating point is determined on the basis of a capacitive charging current of the line.

8. Differential protection method according to one of the preceding claims, **characterized in that**

   - the asymmetry variable is formed only when the absolute value of at least one of the current phasor measured values exceeds a capacitive charging current of the line by a predefined factor.

9. Differential protection method according to one of the preceding claims,
   **characterized in that**

   - the asymmetry variable is formed only when the absolute values of the current phasor measured values are below a threshold dependent on the nominal current of the power grid.

10. Differential protection method according to one of Claims 4 to 9,
    **characterized in that**

    - a region, within which the position of the symmetry variable is allowed, is defined in the complex number plane; and
    - the checking of the transit time difference is suspended if the asymmetry variable is outside the defined region.

11. Differential protection device (12a, 12b) for monitoring a line (11) of a power grid, having

    - a measuring device which has a local timer (CLK) and is configured to capture current phasor measured values at one end (11a, 11b) of the line (11), said values indicating the amplitude and phase angle of a phase current flowing at the end (11a, 11b) of the line (11), and to allocate a timestamp to the current phasor measured values indicating the time of their capture;
    - a communication device which is configured to exchange current phasor measured values via a communication connection (16) with another differential protection device (12a, 12b); and
    - an evaluation device which is configured to form a differential current value with its own current phasor measured values temporally allocated to one another on the one hand, and current phasor measured values received from the other differential protection device (12a, 12b) on the other hand, through vectorial addition, wherein time delay information indicating the time delay between the local timers (CLK) of the measuring devices of the differential protection devices (12a, 12b) is used for the temporal allocation of the current phasor measured values captured at different ends (11a, 11b), wherein the time delay information is determined using a transit-time-based time synchronization method, and to generate a fault signal indicating a fault affecting the line (11) if the differential current value exceeds a predefined threshold value;

    **characterized in that**

    - the differential protection device (12a, 12b) is configured to form a quotient of the current phasor measured values temporally allocated to one another with the formation of an asymmetry variable, wherein the asymmetry variable is used to check a transit time difference of messages transmitted via the communication connection (16), which transit time difference arises on account of transmission times which are different depending on the direction.

12. Differential protection system for monitoring a line (11) of a power grid, having at least two differential protection devices (12a, 12b), wherein a differential protection device (12a, 12b) is provided at each end (11a, 11b) of the line (11), and having a communication connection (16) to which the individual differential protection devices (12a, 12b) are connected in order to transmit current phasor measured values;

    - wherein each of the differential protection devices (12a, 12b)

      - comprises a measuring device which has a local timer (CLK) and is configured to capture current phasor measured values at a respective end (11a, 11b) of the line (11), said values indicating the amplitude and phase angle of a phase current flowing at the end (11a, 11b) of the line (11), and to allocate a timestamp to the current measured values indicating the time of their capture;
      - comprises a communication device which is configured to exchange current phasor measured values via the communication connection (16) with the respective other differential protection device (12a, 12b);

    - and wherein at least one of the differential protection devices (12a, 12b)

      - comprises an evaluation device which is configured to form a differential current value with its own current phasor measured values temporally allocated to one another on the one hand, and current phasor measured values received from the other differential protection device (12a, 12b) on the other hand, through vectorial addition, wherein time delay information indicating the time delay between the local timers of the measuring devices of the differential protection devices (12a, 12b) is used for the temporal allocation of the current phasor measured values captured at different ends, wherein the time delay information is determined using a transit-time-based time synchronization method, and to generate a fault signal indicating a fault affecting the line (11) if the differential current value exceeds a predefined threshold value;

**characterized in that**

- the at least one of the differential protection devices (12a, 12b) is configured to form a quotient of the current phasor measured values temporally allocated to one another with the formation of an asymmetry variable, wherein the asymmetry variable is used to check a transit time difference of messages transmitted via the communication connection (16), which transit time difference arises on account of transmission times which are different depending on the direction.

**Revendications**

1.  Procédé de protection différentiel de contrôle d'une ligne (11) d'un réseau d'alimentation en énergie électrique, dans lequel

    - aux bouts (11a, 11b) de la ligne (11), on relève respectivement par des dispositifs de mesure des valeurs de mesure de vecteur de courant, qui indiquent l'amplitude et l'angle de phase d'un courant de phase passant aux bouts (11a, 11b) respectifs de la ligne (11), dans lequel les dispositifs de mesure ont des horloges (CLK) locales et associent aux valeurs de mesure de vecteur de courant un horodatage indiquant l'instant de leur relevé ;
    - on transmet au moins les valeurs de mesure de vecteur de courant relevées à un bout à un dispositif par l'intermédiaire d'une liaison (16) de communication ;
    - au moyen du dispositif d'analyse, on forme, avec des valeurs de mesure de vecteur de courant associées les unes aux autres dans le temps, une valeur de courant de différence par addition vectorielle, dans lequel, pour l'association dans le temps des valeurs de mesure de vecteur de courant relevées à des bouts (11a, 11b) différents, on tire parti d'une information de décalage dans le temps indiquant un décalage dans le temps entre les horloges (CLK) locales des dispositifs de mesure, dans lequel
    - on détermine l'information de décalage dans le temps par un procédé de synchronisation dans le temps reposant sur un temps de propagation ; et
    - on produit un signal de défaut indiquant un défaut concernant la ligne (11), si la valeur de courant de différence dépasse une valeur de seuil donnée à l'avance ;

    **caractérisé en ce que**

    - on forme, en formant une grandeur de dissymétrie, un quotient des valeurs de mesure de vecteur de courant associées les unes aux autres dans le temps, dans lequel on utilise la grandeur de dissymétrie pour le contrôle d'une différence de temps de propagation de télégrammes transmis par l'intermédiaire de la liaison (16) de communication, qui provient de temps de transmission différents en fonction du sens.

2.  Procédé de protection différentiel suivant la revendication 1,
    **caractérisé en ce que**

    - pour la formation du quotient, on divise la valeur de mesure de vecteur de courant la plus petite en valeur absolue par la valeur de mesure de vecteur de courant la plus grande en valeur absolue.

3.  Procédé de protection différentiel suivant la revendication 2,
    **caractérisé en ce que**

    - on ne forme la grandeur de dissymétrie que si le quotient des valeurs de mesure de vecteur de courant dépasse une valeur minimum donnée à l'avance.

4.  Procédé de protection différentielle suivant la revendication 2 ou 3,
    **caractérisé en ce qu'**

- on étudie la position de la grandeur de dissymétrie dans un plan numérique complexe ; et
- en fonction de la position, on décide de la présence d'une différence de temps de propagation.

5. Procédé de protection différentielle suivant la revendication 4,
   **caractérisé en ce qu'**

   - on produit un message de défaut en fonction de la distance de la position de la grandeur de dissymétrie à un point de travail de référence.

6. Procédé de protection différentielle suivant la revendication 5,
   **caractérisé en ce qu'**

   - on bloque la production du signal de défaut indiquant un défaut concernant la ligne, si la distance de la position de la grandeur de dissymétrie au point de travail de référence dépasse une distance maximum.

7. Procédé de protection différentielle suivant la revendication 5 ou 6,
   **caractérisé en ce qu'**

   - on détermine la position du point de travail de référence en fonction d'un courant de charge capacitif de la ligne.

8. Procédé de protection différentielle suivant l'une des revendications précédentes,
   **caractérisé en ce qu'**

   - on ne forme la grandeur de dissymétrie que si la valeur absolue d'au moins l'une des valeurs de mesure de vecteur de courant dépasse d'un facteur donné à l'avance un courant de charge capacitif de la ligne.

9. Procédé de protection différentielle suivant l'une des revendications précédentes,
   **caractérisé en ce qu'**

   - on ne forme la grandeur de dissymétrie que si des valeurs absolues des valeurs de mesure de vecteur de courant sont en-dessous d'un seuil, qui dépend du courant nominal du réseau d'alimentation en énergie.

10. Procédé de protection différentielle suivant l'une des revendications 4 à 9,
    **caractérisé en ce qu'**

    - on fixe dans le plan numérique complexe un domaine à l'intérieur duquel la position de la grandeur de dissymétrie est autorisée ; et
    - on interrompt le contrôle de la différence de temps de propagation, si la grandeur de dissymétrie est à l'extérieur du domaine fixé.

11. Dispositif (12a, 12b) de protection différentiel pour le contrôle d'une ligne (11) d'un réseau d'alimentation en énergie électrique, comprenant

    - un dispositif de mesure comportant une horloge (CLK) locale, qui est conçue pour relever à un bout (11a, 11b) de la ligne (11) des valeurs de mesure de vecteur de courant, qui indiquent l'amplitude et l'angle de phase d'un courant de phase passant aux bouts (11a, 11b) de la ligne (11), et pour associer aux valeurs de mesure de vecteur de courant un horodatage indiquant l'instant de leur relevé ;
    - un dispositif de communication, qui est conçu pour échanger, par l'intermédiaire d'une liaison (16) de communication, des valeurs de mesure de vecteur de courant avec un autre dispositif (12a, 12b) de protection différentiel ; et
    - un dispositif d'analyse, qui est conçu pour former une valeur de courant de différence par addition vectorielle avec des valeurs de mesure de vecteur de courant propres, associées les unes aux autres dans le temps d'une part et des valeurs de mesure de vecteur de courant reçues de l'autre dispositif (12a, 12b) de protection différentiel, dans lequel, pour l'association dans le temps des valeurs de mesure de courant relevées à des bouts (11a, 11b) différents, on tire parti d'une information de décalage dans le temps indiquant le décalage dans le temps entre les horloges (CLK) locales des dispositifs de mesure des dispositifs (12a, 12b) de protection différentiels, dans lequel on détermine l'information de décalage dans le temps par un procédé de synchronisation dans le temps reposant sur un temps de propagation, et pour produire un signal de défaut indiquant un défaut concernant la ligne (11), si la valeur de courant de différence dépasse une valeur de seuil donnée à l'avance ;

**caractérisé en ce que**

- le dispositif (12a, 12b) de protection différentiel est conçu pour former un quotient des valeurs de mesure de vecteur de courant associées les unes aux autres dans le temps avec formation d'une grandeur de dissymétrie, dans lequel on utilise la grandeur de dissymétrie pour le contrôle d'une différence de temps de propagation de télégrammes transmis par l'intermédiaire de la liaison (16) de communication, qui provient de temps de transmission différents en fonction du sens.

12. Système de protection différentiel pour le contrôle d'une ligne (11) d'un réseau d'alimentation en énergie électrique, comprenant deux dispositifs (12a, 12b) de protection différentiels, dans lequel un dispositif (12a, 12b) de protection différentiel est prévu à chaque bout (11a, 11b) de ligne (11), et comprenant une liaison (16) de communication, par laquelle les divers dispositifs (12a, 12b) de protection différentiels sont en liaison pour la transmission de valeurs de mesure de vecteur de courant ;

- dans lequel chacun des dispositifs (12a, 12b) de protection différentiels

- comprend un dispositif de mesure ayant une horloge (CLK) locale, qui est conçu pour relever à un bout (11a, 11b) respectif de la ligne (11) des valeurs de mesure de vecteur de courant, qui indiquent l'amplitude et l'angle de phase d'un courant de phase passant aux bouts (11a, 11b) de la ligne (11), et pour associer aux valeurs de mesure de courant un horodatage indiquant l'instant de leur relevé ;
- comprend un dispositif de communication, qui est conçu pour échanger des valeurs de mesure de vecteur de courant par l'intermédiaire de liaison (16) de communication avec respectivement l'autre dispositif (12a, 12b) de protection différentiel ;

- et dans lequel au moins l'un des dispositifs (12a, 12b) de protection différentiel

- comprend un dispositif d'analyse, qui est conçu pour former une valeur de courant de différence par addition vectorielle avec des valeurs de mesure de vecteur de courant propres, associées les unes aux autres dans le temps d'une part et des valeurs de mesure de vecteur de courant reçues de l'autre dispositif (12a, 12b) de protection différentiel, dans lequel, pour l'association dans le temps des valeurs de mesure de courant relevées à des bouts différents, on tire parti d'une information de décalage dans le temps indiquant le décalage dans le temps entre les horloges locales des dispositifs de mesure des dispositifs (12a, 12b) de protection différentiels, dans lequel on détermine l'information de décalage dans le temps par un procédé de synchronisation dans le temps reposant sur un temps de propagation, et pour produire un signal de défaut indiquant un défaut concernant la ligne (11), si la valeur de courant de différence dépasse une valeur de seuil donnée à l'avance ;

**caractérisé en ce que**

- **en ce que** le au moins un des dispositifs (12a, 12b) de protection différentiels est conçu pour former un quotient des valeurs de mesure de vecteur de courant associées les unes aux autres dans le temps avec formation d'une grandeur de dissymétrie, dans lequel on utilise la grandeur de dissymétrie pour le contrôle d'une différence de temps de propagation de télégrammes transmis par l'intermédiaire de la liaison (16) de communication, qui provient de temps de transmission différents en fonction du sens.

FIG 1

EP 3 876 373 B1

## FIG 2

$$\Delta I = I_L + I_R$$
$$= 0$$

## FIG 3

$$\Delta I = I_L + I_R$$
$$\neq 0$$

# FIG 4

$$\Delta I = I_L + I_R \qquad \Delta I = I_R + I_L$$

# FIG 5

FIG 6

FIG 7

FIG 8

$C_b = C_b' \times L$

$\underline{I}_{last}$ sinkt

$\underline{I}_{last} \gg \underline{I}_C$

$\underline{I}_{last} = 0$

FIG 9

$C_b = C_b' \times L$

$\underline{I}_{last}$ sinkt

$\underline{I}_{last} \gg \underline{I}_C$

$\underline{I}_{last} = 0$

FIG 10

# FIG 11

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 8154836 B2
- EP 3136528 A1
- US 2013181755 A
- US 2012147941 A